# FASCICULE DE BREVET EUROPEEN

(11) **EP 2 755 919 B1**
(45) Date de publication et mention de la délivrance du brevet: **06.05.2020**
(21) Numéro de dépôt: 12756745.1
(22) Date de dépôt: 12.09.2012
(51) Int. Cl.: C01G 23/053, H01G 9/20

(54) **FORMULATION DE SOLUTIONS COLLOÏDALES À BASE D'OXYDE DE TITANE POUR PROCÉDÉS D'ENDUCTION ET D'IMPRESSION : AMÉLIORATION DU RENDEMENT ET DE LA DURÉE DE VIE DES CELLULES PHOTOVOLTAÏQUES ORGANIQUES PIN-NIP**
FORMULIERUNG EINER KOLLOIDALEN TITANOXIDLÖSUNGSZUSAMMENSETZUNG FÜR BESCHICHTUNGS- UND DRUCKVERFAHREN SOWIE VERBESSERUNG DER AUSGABELEISTUNG UND LEBENSDAUER VON ORGANISCHEN P-I-N/N-I-P-FOTOVOLTAKIKZELLEN
FORMULATION OF COLLOIDAL TITANIUM-OXIDE SOLUTIONS COMPOSITION FOR COATING AND PRINTING METHODS, AND IMPROVEMENT OF THE OUTPUT AND LIFESPAN OF ORGANIC P-I-N/N-I-P PHOTOVOLTAIC CELLS

(30) Priorité: 16.09.2011 FR 1158275
(43) Date de publication de la demande: 23.07.2014
(73) Titulaire: Centre National de la Recherche Scientifique (C.N.R.S.), 75016 Paris (FR); Universite de Nantes, 44000 Nantes (FR); Commissariat à l'Énergie Atomique et aux Énergies Alternatives, 75015 Paris (FR); Ardeje, 26000 Valence (FR)
(72) Inventeur: BROHAN, Luc, René, Roger, F-44240 La Chapelle Sur Erdre (FR); KARPINSKI, Arkadiusz, Michal, F-44300 Nantes (FR); RICHARD-PLOUET, Mireille, F-44240 Suce Sur Erdre (FR); BERSON, Solenn, F-73000 Chambery (FR); GUILLEREZ, Stéphane, F-73610 Lepin Le Lac (FR); BARRET, Mickaël, F-26000 Valence (FR); MOURAO, Jérôme, F-38210 La Riviere (FR)
(74) Mandataire: Lavoix
(86) Numéro de dépôt international: PCT/EP2012/067829
(87) Numéro de publication internationale: WO 2013/050222

(56) Documents cités:
- EP-A1- 1 375 428
- GB-A- 2 473 712
- ALPHONSE P ET AL: "Effect of PEG on rheology and stability of nanocrystalline titania hydrosols", JOURNAL OF COLLOID AND INTERFACE SCIENCE, ACADEMIC PRESS, NEW YORK, NY, US, vol. 337, no. 1, 1 septembre 2009 (2009-09-01), pages 81-87, XP027597743, ISSN: 0021-9797, DOI: 10.1016/J.JCIS.2009.04.087 [extrait le 2009-05-12]
- CHU ET AL: "The effects of pH, molecular weight and degree of hydrolysis of poly(vinyl alcohol) on slot die coating of PVA suspensions of TiO2 and SiO2", COLLOIDS AND SURFACES. A, PHYSICACHEMICAL AND ENGINEERING ASPECTS, ELSEVIER, AMSTERDAM, NL, vol. 302, no. 1-3, 11 mai 2007 (2007-05-11), pages 1-10, XP022070860, ISSN: 0927-7757, DOI: 10.1016/J.COLSURFA.2007.01.041
- B. Todorova, H. Terrisse, M. Richard-Plouet, and L. Brohan: "MONODISPERSED TITANIUM OXIDE PARTICLES WITHNANOMETER SCALE AND NARROW-SIZE DISTRIBUTION INNONAQUEOUS MEDIA", Journées Nationales sur les Technologies Emergentesen Micro-nanofabrication, novembre 2008 (2008-11), XP002685473, Extrait de l'Internet: URL:http://jnte08.trans-gdr.lpn.cnrs.fr/FI LES/p62.pdf [extrait le 2012-10-18]

## Description

La présente invention concerne le domaine de solution colloïdale à base de nanoparticules d'oxyde de titane, et sa mise en oeuvre par impression, notamment par jet d'encre dans le domaine de la production d'énergie à partir de radiations solaires.

La présente invention concerne en particulier une solution colloïdale stable à base de nanoparticules d'oxyde de titane pour la préparation d'un matériau semi-conducteur permettant notamment d'améliorer la durée de vie et/ou le rendement de dispositifs de conversion d'énergie solaire à base d'un tel matériau, et en particulier de dispositifs photovoltaïques.

La présente invention concerne la préparation de cette solution colloïdale, la préparation de matériau semi-conducteur, la préparation de dispositifs de conversion d'énergie solaire, ainsi que leurs utilisations.

La technologie utilisant le silicium cristallin domine le marché de la conversion photovoltaïque depuis plus de 30 ans et représente actuellement près de 80 % des cellules photovoltaïques commercialisées. Toutefois, l'expansion du marché du photovoltaïque est principalement limitée par le coût du Watt crête (Wc ou « Watt peak » en anglais) qui reste élevé. Afin de réduire le coût de fabrication, des technologies en film mince sont en cours de développement industriel, celles-ci incluent les absorbeurs tels que CdTe (Cadmium-Tellure), CIGS (Cuivre-Indium-Gallium-Sélénium), le silicium amorphe, les DSSC (Dye-Sensitized Solar Cells) et OPV (cellules photovoltaïques organiques). Ces nouvelles cellules commencent à apparaître sur le marché. Ainsi 5 MW de cellules solaires organiques et 30 MW de DSSC ont été fabriqués en 2009. Les rendements accessibles en laboratoire se situent entre 8 et 12 % sur de petites surfaces tandis que les dispositifs commercialisés possèdent des rendements inférieurs à 4 %. Leur mise en oeuvre est aisée puisqu'elle exploite les technologies de l'impression standard, de procédé au déroulé avec contact (« roll-to-roll », feuille à feuille, enduction), de jet d'encre, les principaux défis de ce secteur concernant le faible rendement de ces dispositifs et l'instabilité à long terme.

Ainsi l'invention vise à améliorer le rendement de dispositifs de conversion d'énergie à partir de radiations solaires, et/ou leur durée de vie.

La présente invention vise également à diminuer le coût de production de tels dispositifs.

Il a déjà été exploré la préparation de nanoparticules d'oxyde de titane, et en particulier d'oxyde de titane amorphe ou de dioxyde de titane (cristallisé sous forme anatase). Ces nanoparticules sont généralement préparées par des procédés sol-gel à partir de précurseurs d'oxyde de titane tel que l'isopropoxyde de titane (IV) (Ti[OCH(CH₃)₂]₄), le tétra-butyl d'orthotitanate (Ti[C₄H₉O₄]), ou une solution d'oxysulfate de titane (TiOSO₄ à environ 15 % en poids dans l'acide sulfurique dilué), voir par exemple GB 2 473 712 A. Les solvants mis en oeuvre diffèrent selon la nature du précurseur : l'alcool isopropylique ou le butanol en général. Des agents complexants du titane tel que l'acétylacétone (CH₃C(O)CH₂C(O)CH₃) dispersé dans le 2-méthoxyéthanol (CH₃OCH₂CH₂OH)., ou l'éthanolamine (H₂NCH₂CH₂OH), ou la diéthylamine ((CH₃CH₂)₂NH) sont ajoutés aux solutions contenant le précurseur de titane. Le mélange est porté à reflux (environ 80° C) pendant quelques heures (1-2h) puis déposé par enduction centrifuge (« spin-coating ») ou électrodéposition sur un substrat conducteur transparent. Afin d'éliminer les solvants et complexants organiques, le film déposé subit un deuxième traitement thermique à 120-150°C ou 450°C pendant 30min à 1h, selon la nature du substrat polymère ou verre. Le recuit à basse température conduit à une forme amorphe du TiOₓ tandis que le deuxième permet l'obtention de la variété cristallisée anatase de TiO₂.

Les solutions de TiOₓ préparées à partir de précurseurs alcooliques d'oxyde de titane sont coûteuses, sensible à l'atmosphère et à l'eau. Dans ce procédé sol-gel, les mécanismes d'hydrolyse et de condensation d'oxyde de titane ne sont pas contrôlés puisqu'ils dépendent de l'humidité relative et de la température. La cinétique de polycondensation de TiOₓ étant très rapide, il est pratiquement impossible d'obtenir dans ces conditions des solutions de nanoparticules cristallisées présentant une faible dispersion des tailles de particules.

L'étape de recuit obligatoire constitue une limitation sévère, en particulier dans le cadre de la mise en oeuvre de cellules solaires sur substrats polymères. Les performances des cellules organiques dépendent étroitement de la nature des espèces présentes à la surface des nanoparticules et donc du caractère amorphe ou cristallisé de l'oxyde de titane. Il importe de maîtriser la taille, la cristallinité des nanoparticules et la composition chimique de leur surface. Les dépôts d'oxyde de titane amorphe sont réalisés par enduction centrifuge (« spin-coating »), enrobage par immersion (« dip-coating »), ou électrodéposition et aucune formulation de solution colloïdale stable contenant des nanoparticules de dioxyde de titane n'est actuellement adaptée aux techniques d'impression.

Il a été découvert dans la présente invention que l'on peut réaliser des solutions colloïdales à base d'oxyde de titane qui soient stables et utilisables pour préparer des dispositifs de conversion d'énergie solaire, en particulier par impression.

L'utilisation d'une technologie d'impression permet en outre de diminuer significativement les coûts de production d'un dispositif photovoltaïque.

L'invention concerne selon un premier aspect un procédé de préparation d'une solution colloïdale de nanoparticules, caractérisé en ce qu'il comprend (a) la dissolution d'un précurseur d'oxyde de titane dit « précurseur » dans un ou plusieurs solvants dits « solvant du précurseur », et (b) la transformation chimique, de préférence par hydrolyse, dudit précurseur en oxyde de titane et dudit solvant du précurseur en un solvant de solution colloïdale, pour former des nanoparticules d'oxyde de titane dispersées dans le solvant de solution colloïdale, ladite solution colloïdale présentant une viscosité dynamique comprise entre 4 et 60 cP à 20°C et 101 325 Pa.

Le précurseur utilisé pour la présente invention est avantageusement un aqua-oxo chlorure de titane ([Ti₈O₁₂(H₂O)₂₄]Cl₈, HCl, 7H₂O). Un tel précurseur peut être préparé selon le procédé décrit dans la demande internationale WO 2004/101436 à partir de TiOCl₂ (aquo-oxo chlorure de titane, procédé pour sa préparation ; L. Brohan, H. Sutrisno, E. Puzenat, A. Rouet, H. Terrisse. - brevet français du CNRS N° 0305619 ; la demande de brevet européen EP 04 742 604.4; le brevet japonais JP2006-530327, et le brevet américain US7858064). Une préparation de tels précurseurs est également décrite dans la demande internationale WO 03/064324 (Polymère sol-gel à base d'oxyde de titane, L. Brohan & al.; les brevets Français : FR0201055, Européen : EP P1470078; Japonais : JP 2003-563956, et américain : US 121406760, du CNRS)

Il est également possible d'utiliser tout autre précurseur d'oxyde de titane, tel que notamment TiOSO₄, TiCl4 (notamment en milieu aqueux), TiF4, TiOF2, un alcoxyde de titane en milieu acide (acide acétique, H₂SO₄, HCI...).

La transformation du précurseur d'oxyde de titane en oxyde de titane, de préférence cristallisé (de préférence sous forme anatase), est typiquement réalisée par hydrolyse à basse température (de préférence à une température inférieure à 200°C, et généralement comprise entre 20 et 200°C, encore de préférence entre 50 et 180°C, et par exemple 120°C) en présence d'au moins de l'eau et du carbonate de propylène. Les solvants de l'invention sont choisis parmi les solvants autorisant une bonne dispersion du précurseur et la nucléation de nanoparticules d'oxyde de titane. Au moins deux solvants forment le solvant du précurseur d'oxyde de titane. Le « solvant du précurseur» comprend au moins un premier solvant et un deuxième solvant, où le premier solvant est consommé, en totalité ou en partie, par la transformation chimique du deuxième solvant, et où le deuxième solvant est transformé, en totalité ou en partie, de préférence par hydrolyse, en un troisième solvant, ledit solvant de solution colloïdale comprenant au moins le troisième solvant, et éventuellement le premier et/ou le deuxième solvant. Le procédé de l'invention comprend la mise en contact du précurseur d'oxyde de titane avec un solvant biphasé (et de préférence avec l'un des solvants du solvant biphasé, le deuxième solvant étant ajouté ensuite) puis la transformation du solvant biphasé par hydrolyse (ou auto-hydrolyse si le solvant biphasé comprend de l'eau) en un solvant monophasé comprenant des nanoparticules d'oxyde de titane.

Le premier solvant est de l'eau, un solvant présentant une constante diélectrique élevée. Ce solvant permet typiquement la dissolution du précurseur avant la phase de nucléation.

Le deuxième solvant est choisi avantageusement pour contrôler la nucléation et la croissance des nanoparticules d'oxyde de titane.

Selon un mode de réalisation, on peut par exemple dissoudre préalablement des cristaux de précurseur d'oxyde de titane dans le premier solvant. Après dissolution, le deuxième solvant du précurseur d'oxyde de titane est ajouté et la solution est agitée pendant un temps suffisant à la bonne homogénéité de l'ensemble. Le mélange est introduit dans une enceinte en matériau approprié (par exemple en PTFE ou téflon®) qui est ensuite fermée, puis le réacteur (autoclave) peut être chauffé pendant une durée et une température suffisantes pour transformer le précurseur d'oxyde de titane en oxyde de titane, comme par exemple à une température comprise entre 80 et 150 °C, par exemple 120°C, pendant 48h.

Une variante du procédé consiste à opérer sous reflux, notamment pour diminuer le temps de réaction. On peut par exemple utiliser une enceinte en matériau approprié (par exemple en PTFE ou téflon®) équipée d'un condenseur, et d'un moyen de chauffage (par exemple un bain d'huile) muni d'une sonde de température. Les cristaux, préalablement dissous dans le premier solvant, et le second solvant sont ajoutés dans l'enceinte. Le mélange est chauffé pendant une durée et une température suffisantes pour transformer le précurseur d'oxyde de titane en oxyde de titane, de préférence à une température comprise entre 80 et 150 °C pendant 24 heures, sous agitation continue. Cette variante du procédé de l'invention présente l'avantage d'accéder à des solutions colloïdales stables dans des temps plus courts de préparation (24h au lieu de 48h).

On obtient une solution transparente.

La réaction peut donc se réaliser en autoclave ou en réacteur muni d'un dispositif de reflux.

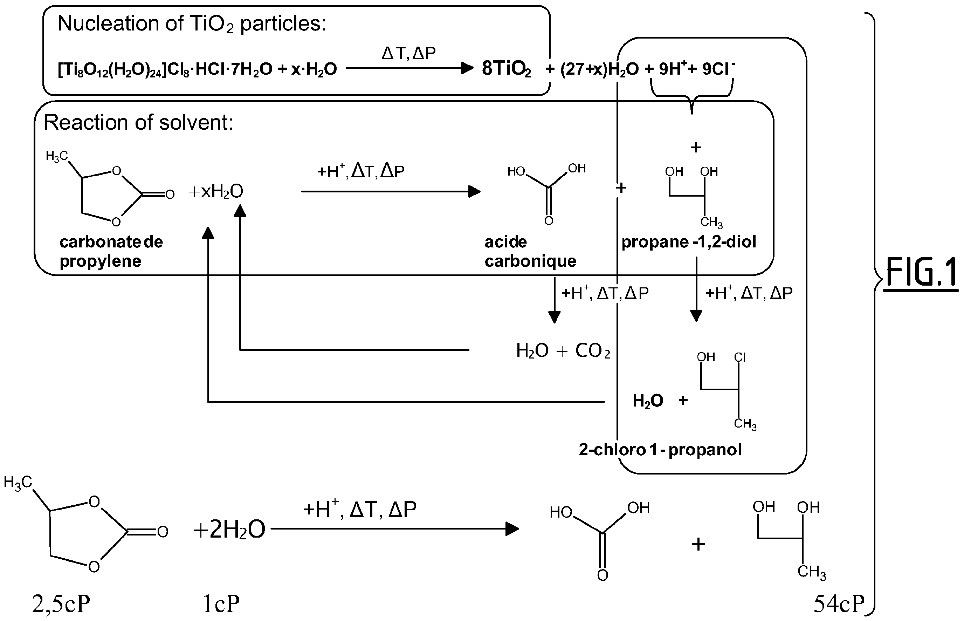

Le deuxième solvant est hydrolysé en milieu acide en un troisième solvant pour générer le solvant de solution colloïdale. Avantageusement cette hydrolyse est réalisée lors de l'hydrolyse du précurseur d'oxyde de titane, comme par exemple selon la figure 1.

La présente invention se base notamment sur le principe de la modification des propriétés du solvant du précurseur (qui peut être un mélange de solvants) pour générer un nouveau système d'un ou plusieurs solvants (solvant de solution colloïdale) dans lequel les nanoparticules d'oxyde de titane formées sont stables. Par stable on entend que la solution présente 12 mois après sa préparation une dispersion des particules comparable, et de préférence sensiblement identique, à la solution colloïdale initiale.

La viscosité de la solution colloïdale est contrôlée par l'arrêt de l'étape de transformation chimique du solvant du précurseur. Ainsi l'ajustement de la concentration des différents réactifs (notamment : précurseur d'oxyde de titane, et acide chlorhydrique utilisé notamment pour l'hydrolyse du précurseur d'oxyde de titane), et des solvants ou composés formant le précurseur de solvant de solution colloïdale conduit à la formation d'une solution colloïdale stable contenant des nanoparticules d'oxyde de titane, et en particulier de dioxyde de titane sous forme d'anatase.

La présente invention permet avantageusement de contrôler la cinétique de transformation du précurseur d'oxyde de titane et dudit solvant du précurseur afin d'ajuster le diamètre et la dispersion en taille des nanoparticules d'oxyde de titane. On cherche à obtenir des nanoparticules dont la taille des particules est peu dispersée, et de préférence monodisperse, et de préférence dont le diamètre hydrodynamique est au maximum de 50nm pour les nanoparticules non agglomérées. Au-delà de 50 nm il a été constaté par les inventeurs que les propriétés de la solution colloïdale ne sont pas suffisamment satisfaisantes pour les applications envisagées, et notamment pour utiliser une technique d'impression, en particulier par jet d'encre. On préfère des nanoparticules dont le diamètre hydrodynamique est centré autour de 5 à 10 nanomètres avec une valeur minimale de 2 nm et maximale de 30 nm, et de préférence 25 nm.

Le solvant du précurseur présente une viscosité dynamique adaptée à solubiliser le précurseur d'oxyde de titane (généralement comprise entre 1 et 3 cP), et la viscosité dynamique de la solution colloïdale de nanoparticules après hydrolyse du précurseur d'oxyde de titane est comprise entre 4 et 54 cP, et par exemple comprise entre 4 et 25 cP, ou encore entre 8 et 15 cP, à 20°C et 101 325 Pa. La mesure de viscosité est typiquement réalisée à l'aide d'un viscosimètre SV-10 Vibro-Viscosimeter (Codemes) : Deux plaques en or sont immergées dans l'échantillon ; l'amplitude de leur vibration, calibrée dans l'eau, varie en fonction de la viscosité du fluide. L'échantillon est placé dans une cuve en verre sur un support thermostaté pour effectuer les mesures à 20°C, température à laquelle les mesures de taille et de potentiel zêta ont été réalisées.

La viscosité est particulièrement adaptée à l'utilisation de la solution colloïdale par impression, et en particulier par impression jet d'encre.

La présente invention permet avantageusement le contrôle de la viscosité lors de la préparation de la solution colloïdale d'oxyde de titane. La viscosité est avantageusement contrôlée par le degré d'avancement de la réaction. En particulier, la viscosité est contrôlée par l'arrêt de l'étape de transformation chimique du solvant du précurseur. Ce contrôle s'effectue notamment par l'intermédiaire des conditions de réaction, et par exemple par la nature des réactifs utilisés (précurseur, solvant, ou autre) ou de leurs concentrations, de la température de réaction, de la pression, du temps de réaction, du rapport molaire entre les réactifs et/ou solvants, ou l'une quelconque des combinaisons de ces paramètres. Cette maîtrise de la réaction permet d'adapter la viscosité de la formulation à l'application souhaitée. Ainsi cette réaction est particulièrement avantageuse pour la préparation de semi-conducteurs par impression.

Le deuxième solvant du précurseur est du carbonate de propylène.

Selon une variante, en milieu acide, il y a hydrolyse du carbonate de propylène qui se transforme en propane-diol et en acide carbonique. En fonction des conditions d'hydrolyse, le propane-diol peut éventuellement s'hydrolyser in fine en 2-chloro-propan-1-ol. C'est le cas notamment en présence d'acide chlorhydrique. La formation de la solution colloïdale résulte d'une double hydrolyse : celle du précurseur d'oxyde de titane et celle du carbonate de propylène.

Si la viscosité des solvants, carbonate de propylène et d'eau est faible, respectivement 2,5 cP et 1 cP, le produit de la réaction (propylène glycol) possède une viscosité de 54 cP à température ambiante. Cette différence offre l'opportunité de formuler la solution avec la viscosité souhaitée en contrôlant le degré d'avancement de la réaction. II faut donc choisir de préférence des solvants hydrolysables ou transformables chimiquement, dont la viscosité est significativement différente avant et après hydrolyse ou transformation chimique.

Ainsi la présente invention permet avantageusement de faire évoluer (augmenter ou diminuer, et de préférence faire augmenter) la viscosité de manière à initialement solubiliser le précurseur d'oxyde de titane, puis à former des nanoparticules d'oxyde de titane stables notamment par la modification contrôlée de la viscosité du solvant du précurseur.

La cinétique d'hydrolyse du mélange carbonate de propylène (PC)-eau acide dépend notamment de leurs proportions initiales. Ainsi, le solvant du précurseur comprend de l'eau (premier solvant), et du carbonate de propylène (PC) (deuxième solvant), avec de préférence un rapport molaire [eau]/[PC] compris entre 0,1 et 1,5, et de préférence entre 0,2 et 1,2, et encore de préférence compris entre 0,5 et 0,8.

Selon une variante non-inventive, le précurseur de solvant de solution colloïdale comprend de l'eau et du propylène glycol. Le rapport molaire [eau]/[PG] est de préférence compris entre 0,1 et 1,5, et de préférence entre 0,1 et 0,7.

La température d'hydrolyse est de préférence comprise entre 100 et 150°C.

La tension de surface du solvant du précurseur est de préférence comprise entre 20 et 40 mN/m.

La durée d'hydrolyse est comprise de préférence entre 90 minutes et 70 heures, de préférence entre 8 et 60h, à une température de 120°C.

La concentration des précurseurs d'oxyde de titane est avantageusement comprise entre 0,005 et 0,2 M.L⁻¹ (soit 0,0185 et 0,741 g de Ti₈O₁₂) et de préférence entre 0,02 et 0,1 M.L⁻¹ (typiquement [Ti]= 0,027 à 0,054 M.L⁻¹ soit 0,1 et 0,2 g de Ti₈O₁₂) dans le solvant initial. La concentration est exprimée en gramme de titane pour des raisons de facilité.

La formulation de la solution colloïdale pour l'impression jet d'encre nécessite un ajustement précis de la viscosité, généralement entre 8 et 15 cP à la température d'impression, qui peut être contrôlée par un élément chauffant à l'intérieur du module d'impression.

Avantageusement, la présente invention permet également le contrôle du pH de la solution colloïdale d'oxyde de titane. Pour la mise en oeuvre des techniques d'impression il est avantageux de contrôler le pH des solutions colloïdales afin de prévenir une éventuelle corrosion des modules d'impression. Le pH ainsi contrôlé est également avantageux pour protéger de la corrosion de tout autre dispositif mis en contact avec la solution colloïdale.

Selon un mode de réalisation particulier, lors de la mise en contact du précurseur d'oxyde de titane avec le mélange de solvant (carbonate de propylène-eau) il y a formation intermédiaire de 1,2 propane-diol (ou propylène glycol) qui, par réaction d'échange nucléophile, se transforme en 2-chloro-1-propanol. Ici trois réactions chimiques se produisent dont les cinétiques diffèrent selon les conditions initiales et de réaction (Figure 1). Ainsi la transformation du précurseur d'oxyde de titane en oxyde de titane produit de l'acide chlorhydrique, et l'acide chlorhydrique produit est consommé par réaction avec au moins un composé dudit solvant de solution colloïdale ou un composé formé lors de la transformation chimique du solvant du précurseur.

Il est donc possible de contrôler la viscosité de la solution colloïdale résultante et de la neutraliser à un pH convenable pour les utilisations envisagées.

Selon une variante, on ajoute au solvant du précurseur du solvant de solution colloïdale, ou un solvant faisant partie du solvant de solution colloïdale. On peut ainsi ajouter le troisième solvant défini ci-dessus au solvant du précurseur. Typiquement on peut ajouter du propylène glycol à un mélange eau-carbonate de propylène. Ceci permet d'améliorer significativement les propriétés rhéologiques et de diminuer la dispersité des nanoparticules dans la solution colloïdale.

Selon une autre variante, la solution colloïdale de nanoparticules d'oxyde de titane est exposée aux rayons UV pour améliorer ses propriétés d'absorption du rayonnement solaire.

L'invention concerne selon un second aspect une solution colloïdale de nanoparticules d'oxyde de titane comprenant une dispersion de nanoparticules d'oxyde de titane dans un solvant ou système de solvants dont la viscosité est comprise entre 4 et 54 cP, à 20°C et à 101 325 Pa, qui est obtenue par le procédé inventif.

La solution colloïdale comprend de préférence des nanoparticules d'oxyde de titane sous forme d'anatase. D'après les procédés de préparation de solution colloïdale de nanoparticules d'oxyde de titane, les méthodes antérieures ne permettent pas d'obtenir des solutions colloïdales stables contenant des nanoparticules d'oxyde de titane cristallisé (anatase). C'est le cas notamment de la méthode décrite dans la demande internationale WO 03/064324 (Polymère sol-gel à base d'oxyde de titane). Selon ce procédé antérieur, la solution colloïdale obtenue comprend, selon la concentration en titane initiale et le temps de vieillissement, des nanoparticules de diamètre hydrodynamique 1,5 nm, ou des réseaux polymériques bidimensionnels d'oxyde de titane. La demande WO 2004/101436 ne permet pas d'obtenir une solution stable ni des nanoparticules cristallisées. La présente invention permet la préparation d'une solution colloïdale stable contenant des nanoparticules d'anatase, monocristallines. On peut parler de nanocristaux d'oxyde de titane. Les nanoparticules de l'invention présentent de préférence un diamètre hydrodynamique compris entre 2 et 50 nm et les agrégats, s'ils sont présents, présentent de préférence un diamètre hydrodynamique compris entre 50 et 250 nm, et de préférence comprise entre 50 et 180 nm. Idéalement les solutions colloïdales de l'invention ne comprennent pas d'agrégats (ou sensiblement pas) ou sont éliminés. Selon certaines variantes de l'invention, les nanoparticules ont tendance à s'agglomérer entre elles et donc à faire naître une population de particules qui n'est pas suffisamment monodisperse. Cette agglomération peut être évitée par le traitement de la solution colloïdale de telles nanoparticules par une illumination sous radiation UV. Typiquement ce traitement consiste en une exposition de la solution colloïdale à un rayonnement UV comme par exemple à une longueur d'onde de 365nm, pendant un temps suffisant pour éliminer les agrégats éventuellement présents. Cette durée est typiquement comprise entre 1 et 24h.

L'invention concerne donc en particulier une solution colloïdale de nanoparticules mono-disperses.

La solution colloïdale de l'invention est susceptible d'être obtenue par l'un quelconque des procédés décrits ci-dessus ou ci-dessous y compris toutes combinaisons des variantes ou modes de réalisations.

Le solvant de la solution colloïdale est avantageusement obtenu comme décrit ci dessus. En particulier, ce solvant est obtenu par hydrolyse du solvant du précurseur d'oxyde de titane. On parle en particulier d'auto-hydrolyse du solvant lorsque celui-ci contient de l'eau puisque que l'eau (une partie au moins) du solvant du précurseur sert à hydrolyser le ou les autres solvants du précurseur.

La solution colloïdale de l'invention forme notamment un matériau sol-gel. en particulier la solution colloïdale de l'invention comprend ou est constituée de nanoparticules d'oxyde de titane et en particulier de dioxyde de titane sous forme anatase, dispersée dans du 2-chloro-1-propanol comprenant éventuellement du propylène glycol et/ou de l'eau.

La présente invention concerne selon un troisième aspect l'utilisation d'une solution colloïdale telle que définie précédemment, ou susceptible d'être obtenue selon le procédé de l'invention, pour la préparation d'un semi-conducteur de type n.

L'invention concerne encore selon un quatrième aspect un procédé de préparation d'une couche de semi-conducteur de type n comprenant la préparation d'une solution colloïdale telle que définie précédemment, et le dépôt d'une couche de solution colloïdale sur un substrat pour former une couche de semi-conducteurs de type n comprenant des nanoparticules d'oxyde de titane.

Le dépôt est de préférence opéré par impression ou enduction, et encore de préférence par enduction centrifuge (« spin coating »), impression par jet d'encre, par sérigraphie (« screen printing »), héliogravure, et/ou par procédé au déroulé avec contact (« roll-to-roll »), éventuellement en utilisant un ou plusieurs motifs sur le substrat (« patterning »). L'emploi de l'impression jet d'encre permet de réaliser une couche directement structurée correspondant au dessin souhaité et les paramètres associés au procédé de contrôler les caractéristiques des couches réalisées (épaisseur, couche sous-jacente, etc.). Ce procédé permet également de minimiser les pertes de matières dans la mise en oeuvre.

Le procédé peut comprendre le dépôt en solution sur un substrat suivi d'un recuit à une température comprise entre 50 et 500° C de préférence entre 50 et 200° C.

Typiquement, on dépose sur un substrat conducteur ou semi-conducteur transparent une solution colloïdale telle que décrite précédemment.

L'ajout d'autres co-solvants (comme d'autres alcools et/ou éthers de glycol) peut permettre d'améliorer les formulations pouvant être mises en oeuvre par jet d'encre en respectant les caractéristiques de la solution mère (stabilité, ...) et les caractéristiques des couches obtenues (morphologie, transparence, résistivité, travail de sortie,...)

L'invention concerne selon un cinquième aspect un dispositif photovoltaïque comprenant un matériau semi-conducteur de type n susceptible d'être obtenu selon les procédés décrits précédemment. Ce dispositif est typiquement une cellule photovoltaïque de type PIN ou NIP, un transistor organique, ou une diode électroluminescente. L'invention concerne en particulier une cellule photovoltaïque organique.

L'invention concerne selon un sixième aspect un procédé de fabrication d'un dispositif photovoltaïque comprenant le dépôt sur un substrat de la solution colloïdale (sous forme typique de matériau sol-gel). Suivant la nature du substrat, la couche du matériau n peut être recuite entre 50 et 200°C. Son épaisseur est par exemple comprise entre 10 et 200 nm. La couche active du dispositif photovoltaïque est ensuite généralement déposée sur la couche de matériau n. Un traitement en température comprise entre 50 et 180°C pendant 0 à 30 minutes permet souvent une optimisation de la morphologie de la couche active. Une couche interfaciale de type p est ensuite généralement déposée sur la couche active. Un traitement thermique à une température typiquement comprise entre 50 et 180°C de 0 à 30 minutes permet habituellement l'optimisation des performances du dispositif. Une électrode est ensuite typiquement déposée par voie liquide ou par évaporation sous vide sur la couche de type P.

La cathode et l'anode sont constituées typiquement:
soit de matériaux conducteurs :
- métaux (argent, titane, aluminium, calcium, magnésium, etc.)
- ou oxydes métalliques (In₂O₃ dopé Sn⁴⁺ ou ITO, ZnO dopé Al³⁺ ou AZO, ZnO dopé indium ou IZO, SnO₂ dopé F ou FTO)
- ou matériaux inorganiques/hybrides (matériau à base de nanotubes de carbone ou NTCs, graphène),
- ou matériaux organiques conducteurs type PEDOT : PSS, polythiophènes dopés,
- ou un empilement de deux de type ITO/Ag/ITO.

La couche active est généralement composée d'un matériau semi-conducteur de type n (fullerènes, dérivés du fullerène, pérylène, polymères semi-conducteurs de type n, etc.) en mélange avec un matériau semi-conducteur de type p (P3HT, polythiophène et ses dérivés, copolymères de polythiophène ou polycarbazole, etc).

La couche interfaciale de type p comprend en général un polymère conducteur de type p (PEDOT : PSS, polythiophènes dopés, etc) ou oxyde métallique semi-conducteur (V₂O₅, MoO₃ NiO, WO₃).

Selon un mode de réalisation préféré, à partir de la solution colloïdale de l'invention, la couche d'oxyde de titane est réalisée par impression jet d'encre à l'aide d'une plate-forme d'impression intégrant des modules d'impression générant des gouttes de 1 à 100pL (picolitres). Suivant la nature de la couche sous-jacente, les stratégies d'impression sont adaptées afin d'obtenir des couches homogènes d'épaisseur visée. De même la concentration en oxyde de titane de la solution colloïdale utilisée est adaptée en fonction de la stratégie d'impression. Le recuit thermique éventuellement appliqué est de préférence similaire à celui utilisé pour les couches réalisées par enduction. En général la couche n est utilisée sur une surface conductrice ou semi-conductrice pour dispositif photovoltaïque organique ou hybride, photodiode (comme pour des applications de capteurs), ou diode électroluminescente pour les surfaces conductrices ou semiconductrices.

Les solutions colloïdales de l'invention sont stables et compatibles avec les techniques d'impression.

L'utilisation des solutions colloïdales de l'invention permet d'augmenter la durée de vie de dispositifs photovoltaïques. La durée de vie est typiquement d'au moins 6500 heures avec une perte de rendement inférieure à 15 %.

Les rendements (de conversion en puissance PCE - en anglais « Power Conversion Efficiency ») du dispositif photovoltaïque de la présente invention sont typiquement de 2 à 5 %.

La présente invention concerne également une méthode de production d'énergie comprenant l'utilisation d'un matériau semi-conducteur de type n susceptible d'être obtenu selon les procédés décrits précédemment, ou d'un dispositif photovoltaïque, tel que défini précédemment, pour produire de l'énergie, et en particulier de l'électricité, à partir de radiations solaires.

Les figures représentent :
Figure.1 : Schéma de synthèse des solutions colloïdales ;
Figure 2 : Evolution de la viscosité finale des solutions colloïdales en fonction du rapport molaire eau/carbonate de propylène ;
Figure 3 : spectres FTIR des solutions colloïdales en fonction du rapport molaire initial R=[H2O]/[PC] ;Figure 4 : Comparaison des viscosités finales de solutions colloïdales et de solvants de référence dans différents rapports molaires ;
Figure 5 : Evolution de la viscosité des solutions colloïdales (a) et du taux de conversion calculé (b) en fonction du rapport molaire initial R = [H₂O]/[PC] ;
Figure 6 : Evolution de la viscosité de la solution, selon l'exemple 2, avec R=0,712 en fonction de la durée du traitement thermique ;
Figure 7 : Evolution de la conductivité de la solution colloïdale, selon l'exemple 3, pour R=0,712 en fonction de la durée du traitement thermique à T=120°C ;
Figure 8 : Evolution de la conductivité d'une solution colloïdale en fonction du rapport R et pour différentes concentrations du précurseur ;
Figure 9 : Distribution de diamètres des particules (en nanomètres), pour différents rapports molaires R=[H2O]/[PC] (0,285 <R< 1,14) de solutions colloïdales, en fonction du volume ou de l'intensité diffusée ;
Figure 10 : Diamètre des nanoparticules et agrégats en fonction de la formulation initiale des solutions colloïdales ;
Figure 12 : Images de Microcopie électronique à transmission, Solution colloïdale diluée 100 fois dans l'éthanol, après illumination sous UV pendant 12h ;
Figure 13 : Taille des particules des solutions de l'exemple 5 (nanomètres) en fonction du rapport molaire initial R ;
Figure 14 : Photographies de l'étude de photosensibilité sous illumination UV (solution N°8 à gauche et solutions N°12 à droite, UV=365nm, 1mW /cm²) ;
Figure 15 : Spectre d'absorbance UV-visible de la solution N°23, R=[H2O]/[PC]=0,855 avant et après différents temps d'illumination sous UV=365nm ;
Figures 16, 17 : Images au microscope électronique haute résolution de la solution N°24 (R=0,171) (figure 16) et N°25 (R=0,555) (figure 17) ; les solutions colloïdales étant diluées 10 fois dans l'éthanol ;
Figure 18: Diagramme de diffraction de rayons X des poudres obtenues par séchage des solutions 24 et 25 à 70°C ;
Figure 19 : Vue schématique de différents constituants de cellule photovoltaïque PIN ou NIP
Figure 20: Capture de gouttes en vol à la sortie d'un module d'impression industriel avant et après optimisation des paramètres d'éjection (formulation optimisée pour le jet d'encre à partir d'une solution colloïdale de TiOₓ) ;
Figure 21 : Microscopie électronique à balayage d'une couche de TiOₓ imprimée par jet d'encre sur un substrat verre/ITO (étapes du processus de fabrication d'une cellule OPV en structure NIP ; (a) grossissement x 20 000, (b) grossissement x 80 000) ;
Figures 22, 23 : Performances de conversion photovoltaïque des dispositifs réalisés (PCE en % ou normalisé) en fonction de la durée testée ;
Figure 24 : Distribution par PCS (Spectroscopie de Corrélation de Photons ou en anglais « Photon Corrélation Spectroscopy ») de la taille (diamètre hydrodynamique en nanomètres) des particules de la solution colloïdale N°9 (exemple 4) avant illumination sous UV.

D'autres buts, caractéristiques et avantages de l'invention apparaîtront clairement à l'homme de l'art suite à la lecture de la description explicative qui fait référence à des exemples qui sont donnés seulement à titre d'illustration et qui ne sauraient en aucune façon limiter la portée de l'invention.

Les exemples font partie intégrante de la présente invention et toute caractéristique apparaissant nouvelle par rapport à un état de la technique antérieure quelconque à partir de la description prise dans son ensemble, incluant les exemples, fait partie intégrante de l'invention dans sa fonction et dans sa généralité.

Ainsi, chaque exemple a une portée générale.

D'autre part, dans les exemples, tous les pourcentages sont donnés en poids, sauf indication contraire, et la température est exprimée en degré Celsius sauf indication contraire, et la pression est la pression atmosphérique, sauf indication contraire.

### Exemples

### Exemple 1 : Préparation de solutions colloïdales TiOx/TiO2

La synthèse des solutions colloïdales est basée sur la transformation du précurseur [Ti₈O₁₂(H₂O)₂₄]Cl₈•HCl•7H₂O en nanoparticules de TiO₂. La réaction est effectuée à base température (120°C) en présence d'un mélange binaire de solvants constitué de carbonate de propylène et d'eau. Les solvants sélectionnés autorisent une bonne dispersion du précurseur et la nucléation de nanoparticules de TiO₂. L'utilisation du solvant à forte constante diélectrique (eau) permet la dissolution du précurseur avant la phase de nucléation. Le carbonate de propylène (ester cyclique) permet le contrôle de la nucléation-croissance de TiO₂. Lors de sa réaction avec le précurseur acide d'oxyde de titane, il y a formation du 1,2 propane-diol (ou propylène glycol), de 2-chloro-1-propanol avec consommation des molécules d'eau, et libération de dioxyde de carbone. L'ajustement de la concentration des réactifs et de la proportion des solvants (eau/carbonate de propylène) conduit à la formation de solutions colloïdales stables contenant des nanoparticules de TiO₂ (Les solutions préparées dans les exemples sont stables 12 mois après leur préparation, c'est-à-dire que la dispersion des nanoparticules est sensiblement identique à celle des solutions colloïdales initialement préparées).

Lors de l'ajout du précurseur de titane au mélange de solvants carbonate de propylène-eau il y a formation intermédiaire de 1,2 propane-diol (ou propylène glycol) qui spontanément s'hydrolyse en milieu acide en 2-chloro-1-propanol (figure.1 : Schéma de synthèse des solutions colloïdales). La formation des solutions colloïdales résulte d'une double hydrolyse celle du précurseur [Ti₈O₁₂(H₂O)₂₄]Cl₈•HCl•7H₂O et celle du carbonate de propylène.

### Exemple 2 : Contrôle de la viscosité des solutions colloïdales de TiO₂

La viscosité de la formulation de la solution colloïdale pour les applications envisagées, et en particulier pour l'impression jet-d'encre, peut être ajustée précisément, par exemple pour obtenir une viscosité comprise entre 8 et 15cP à la température d'impression (température des buses d'impression, généralement comprise entre 20 et 80°C) et à la pression atmosphérique.

### • Conditions expérimentales

Les solutions colloïdales sont préparées à partir de [Ti₈O₁₂(H₂O)₂₄]Cl₈•HCl•7H₂O comme précurseur de titane (réalisé au laboratoire par hydrolyse d'une solution aqueuse de TiOCl₂, de concentration typiquement 1,5 M. L⁻¹ en Titane, sous humidité relative contrôlée (Relative Humidity, RH=50-60%), selon le protocole de la demande internationale WO 2004/101436 du CNRS (aquo-oxo chlorure de titane, procédé pour sa préparation ; L. Brohan, H. Sutrisno, E. Puzenat, A. Rouet, H. Terrisse), de carbonate de propylène (Sigma-Aldrich 99.7%) et d'eau Milli-Q. Les cristaux de [Ti₈O₁₂(H₂O)₂₄]Cl₈•HCl•7H₂O sont préalablement dissouts dans l'eau. Après dissolution, le carbonate de propylène est ajouté et la solution est agitée pendant 5 minutes. Le mélange est introduit dans une enceinte en téflon (46 ml) qui est ensuite fermée puis le réacteur (autoclave) est porté à 120°C pendant 48h. Les quantités relatives de réactifs sont précisées dans le tableau 1.

**Tableau 1 : Proportion des réactifs et viscosité des solutions colloïdales à température ambiante, après traitement en autoclave à 120°C pendant 48 h**

| N° des Solutions | 7 | 8 | 9 | 10 | 11 | 12 |
|---|---|---|---|---|---|---|
| Ti₈O₁₂ (en g) | 0,18 | 0,18 | 0,18 | 0,18 | 0,18 | 0,18 |
| H₂O [mL] | 1 | 2 | 2,5 | 3 | 3,5 | 4 |
| H₂O [mole] | 0,056 | 0,111 | 0,139 | 0,167 | 0,194 | 0,222 |
| PC[mole] | 0,195 | 0,195 | 0,195 | 0,195 | 0,195 | 0,195 |
| R=[H₂O]/[PC] | 0,285 | 0,570 | 0,712 | 0,855 | 0,997 | 1,140 |
| viscosité finale [cP] | 4,38 | 8,95 | 13,8 | 23,1 | 46 | 48,3 |

| | | | | | | |
|---|---|---|---|---|---|---|
| 0,18 g de Ti₈O₁₂ représente une concentration en titane : [Ti]= 0,05 M.L-1 | | | | | | |

### • Influence de la proportion des réactifs

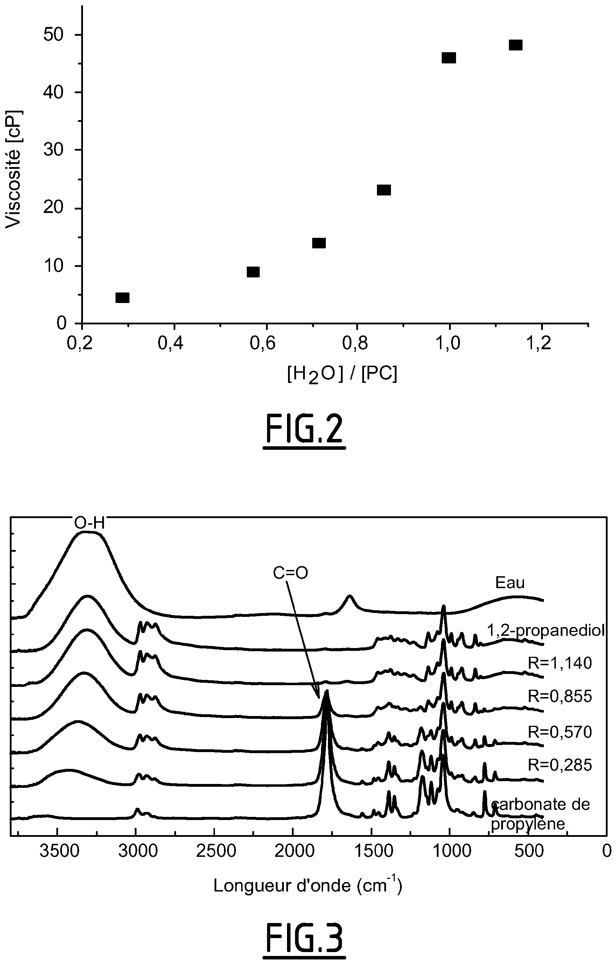

La cinétique d'hydrolyse du mélange carbonate de propylène-eau acide dépend fortement de leur proportion initiale. La figure 2 et le tableau 1 montrent l'évolution de la viscosité finale des solutions colloïdales en fonction du rapport molaire eau/carbonate de propylène, après 48 heures de réaction à 120°C.

L'ajustement de la quantité d'eau contrôle l'avancement de la réaction et par suite la viscosité. Ainsi, les solutions colloïdales possèdent des viscosités comprises entre 4,4 et 48cP. L'hydrolyse totale du carbonate de propylène s'écrit:

C4H6O3 + H2O => C3H8O2 + CO2

Les spectres FTIR des solutions colloïdales (figure 3) évoluent continûment en fonction du rapport molaire initial R=[H2O]/[PC] et sont comparés aux spectres des solvants de référence sur la figure 3. L'hydrolyse du carbonate de propylène en 1,2 propane-diol se manifeste par la disparition du mode de vibration associé au groupement carbonyle à 1780 cm⁻¹ et par l'apparition du mode de vibration de OH à 3400cm⁻¹ dû à la formation du 1,2 propane-diol. Dans tous les cas, le mode de vibration à 1650 cm⁻¹ attribuable à la présence d'eau est absent. Pour R=[H2O]/[PC]=1,14, le spectre est comparable à celui du 1,2 propane-diol. Toutefois, la viscosité de la solution vaut 48cP et reste donc inférieure à celle du propylène glycol pur, 54cP.

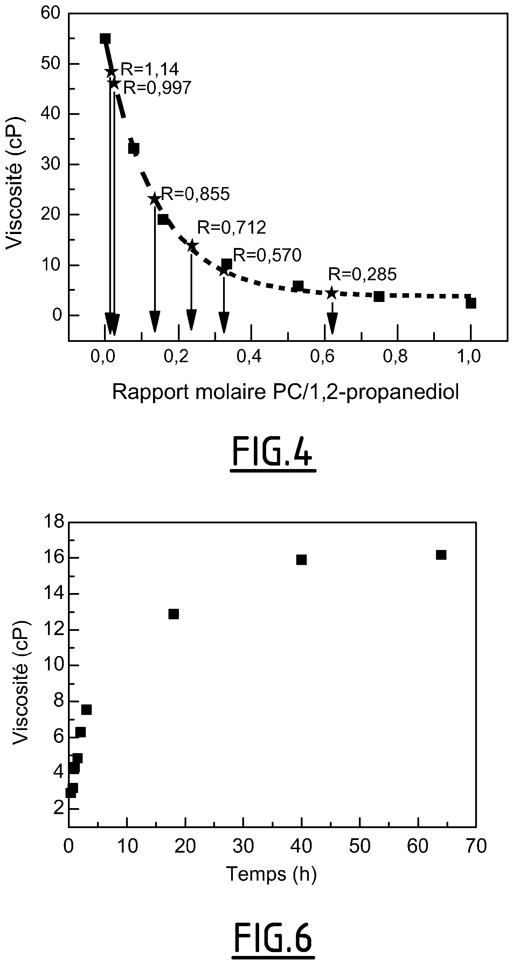

Puisque, lors de la réaction d'hydrolyse, les molécules d'eau disparaissent et que seuls subsistent le carbonate de propylène et le propylène glycol, il est possible de maîtriser l'évolution de la réaction et par suite de contrôler la viscosité des solutions colloïdales. Sur la figure 4 sont comparées les viscosités finales des solutions colloïdales et des solvants de référence (carbonate de propylène et 1,2 propane-diol) dans différents rapports molaires. Le degré d'avancement de la réaction est estimé à partir de la courbe de référence (en pointillé) et les valeurs pour différentes solutions colloïdales sont regroupées dans le tableau 2.

**Tableau 2 : Etat d'avancement de la réaction pour différentes solutions colloïdales déduit des équations 1 et 2.**

| N° des Solutions | 1 | 2 | 3 | 4 | 5 | 6 |
|---|---|---|---|---|---|---|
| Initial R=[H₂O]/[PC] | 0,285 | 0,570 | 0,712 | 0,855 | 0,997 | 1,14 |
| Composition finale [PC]/[PG] | 0,623 | 0,320 | 0,228 | 0,136 | 0,026 | 0,019 |
| Degré de Conversion de PC en PG | 37,7% | 68,0% | 77,2% | 86,4% | 97,4% | 98,1% |

Les résultats expérimentaux montrent qu'il est possible en ajustant le rapport [H2O]/[PC] entre 0,285 et 1,14 de contrôler la viscosité de la solution colloïdale de 4.4cP à 48cP à température ambiante (20°C).

### • Influence de la quantité de précurseur

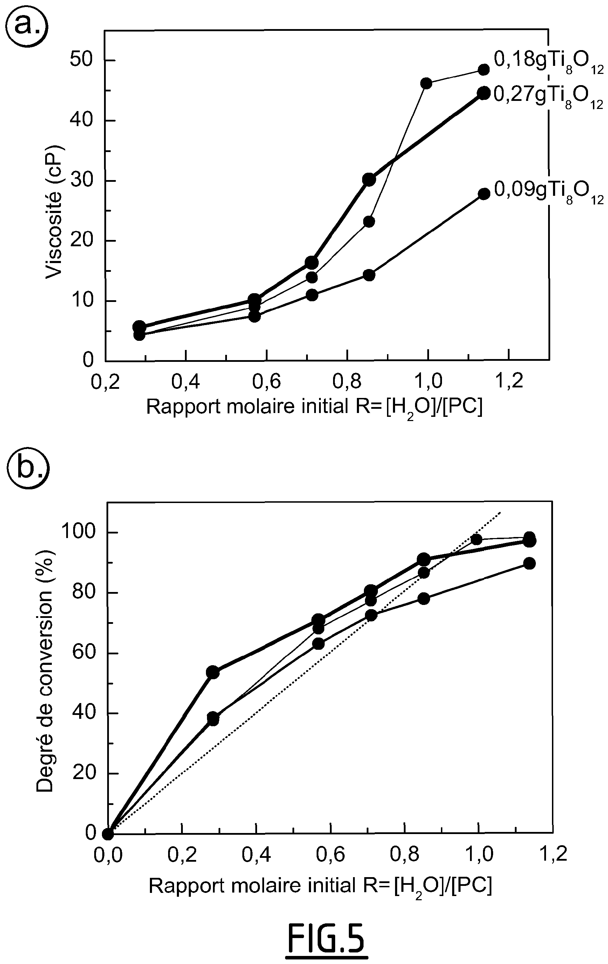

La quantité de protons H⁺ libérés lors de la dissolution de [Ti₈O₁₂(H₂O)₂₄]Cl₈•HCl•7H₂O influe sur la cinétique et le taux d'hydrolyse du carbonate de propylène. Trois concentrations en [Ti₈O₁₂(H₂O)₂₄]Cl₈•HCl•7H₂O ont été testées en fonction de différents rapports R=[H2O]/[PC]. La température et le temps de réaction sont maintenus à 120°C et 48h, respectivement. La figure 5 présente l'évolution de la viscosité des solutions colloïdales (a) et du taux de conversion calculé (b) en fonction du rapport molaire initial R = [H₂O]/[PC]. La ligne pointillée représente le taux de conversion théorique et les courbes d'épaisseur moyenne, fine, et importante le taux de conversion pour les valeurs 0,09g, 0,18g et 0,27g de [Ti₈O₁₂(H₂O)₂₄]Cl₈•HCl•7H₂O, respectivement. Les valeurs massiques et molaires des réactifs ainsi que celles de la viscosité des solutions colloïdales sont regroupées dans le tableau 3.

**Tableau 3 : Composition chimique initiale des réactifs et viscosité des solutions colloïdales.**

| N° des Solutions | Ti₈O₁₂ (g) | H₂O (moles) | PC (moles) | R=[H₂O]/[PC] | Viscosité en (cP) (20°C) |
|---|---|---|---|---|---|
| 1 | 0,09 | 0,056 | 0,195 | 0,285 | 4,42 |
| 2 | 0,09 | 0,111 | 0,195 | 0,570 | 7,4 |
| 3 | 0,09 | 0,139 | 0,195 | 0,712 | 10,9 |
| 4 | 0,09 | 0,167 | 0,195 | 0,855 | 14,2 |
| 5 | - | - | - | - | - |
| 6 | 0,09 | 0,222 | 0,195 | 1,140 | 27,6 |
| 7 | 0,18 | 0,056 | 0,195 | 0,285 | 4,38 |
| 8 | 0,18 | 0,111 | 0,195 | 0,570 | 8,95 |
| 9 | 0,18 | 0,139 | 0,195 | 0,712 | 13,8 |
| 10 | 0,18 | 0,167 | 0,195 | 0,855 | 23,1 |
| 11 | 0,18 | 0,194 | 0,195 | 0,997 | 46 |
| 12 | 0,18 | 0,222 | 0,195 | 1,140 | 48,3 |
| 13 | 0,27 | 0,056 | 0,195 | 0,285 | 5,63 |
| 14 | 0,27 | 0,111 | 0,195 | 0,570 | 10,1 |
| 15 | 0,27 | 0,139 | 0,195 | 0,712 | 16,3 |
| 16 | 0,27 | 0,167 | 0,195 | 0,855 | 30,1 |
| 17 | - | - | - | - | - |
| 18 | 0,27 | 0,222 | 0,195 | 1,140 | 44,4 |

| | | | | | |
|---|---|---|---|---|---|
| 0,09 g de Ti₈O₁₂ représente une concentration en titane : [Ti]= 0,025 M.L-1 0,18 g de Ti₈O₁₂ représente une concentration en titane : [Ti]= 0,05 M.L-1 0,27 g de Ti₈O₁₂ représente une concentration en titane : [Ti]= 0,075 M.L-1 | | | | | |

Les solutions aqueuses de faible concentration en précurseur de titane ([Ti]=0,025 M. L⁻¹) n'autorisent pas une hydrolyse complète du carbonate de propylène en raison d'une acidité trop faible tandis que 98% du carbonate de propylène est hydrolysé lorsque la solution contient 0,18g de précurseur ([Ti]=0,05 M. L⁻¹).

### • Influence de la durée du traitement thermique

Pour une température donnée (120°C), le temps de réaction dans l'autoclave est également un facteur déterminant de l'avancement de l'hydrolyse du carbonate de propylène. Ce paramètre a été testé à partir de la solution avec R=0,712 (solution N°9, Tableau 3). Les échantillons sont traités en autoclave à 120°C pendant des durées variables. L'évolution de la viscosité de la solution avec R=0,712 en fonction de la durée du traitement thermique est présentée sur la figure 6.

En dessous de 90 minutes (1,5 h sur la figure 6) le système reste biphasé (il y a ségrégation des phases aqueuse et carbonate de propylène) en raison de la faible miscibilité des solvants. La solubilité de l'eau dans le carbonate de propylène est de 8,3% et celle du carbonate de propylène dans l'eau de 17,5% à 25°C. Au delà de 90mn le mélange devient homogène (monophasé). Le 1,2 propane-diol (propylène glycol) produit au cours de la réaction augmente la solubilité mutuelle des solvants. La figure 6 indique que l'hydrolyse du propylène glycol est complète après 60 heures de traitement thermique à 120°C et pour R=0,712.

### Exemple 3 : Neutralisation de la solution colloïdale

La mise en oeuvre de techniques d'impression nécessite de contrôler le pH des solutions colloïdales afin de prévenir une éventuelle corrosion des modules d'impression. L'une des étapes du procédé de l'invention peut être une hydrolyse en milieu aqueux du précurseur de titane conduisant à la formation d'acide chlorhydrique selon:
- [Ti₈O₁₂(H₂O)₂₄]Cl₈•HCl•7H₂O + x•H₂O => 8TiO₂ + (27+x)H₂O + 9H⁺+ 9Cl⁻

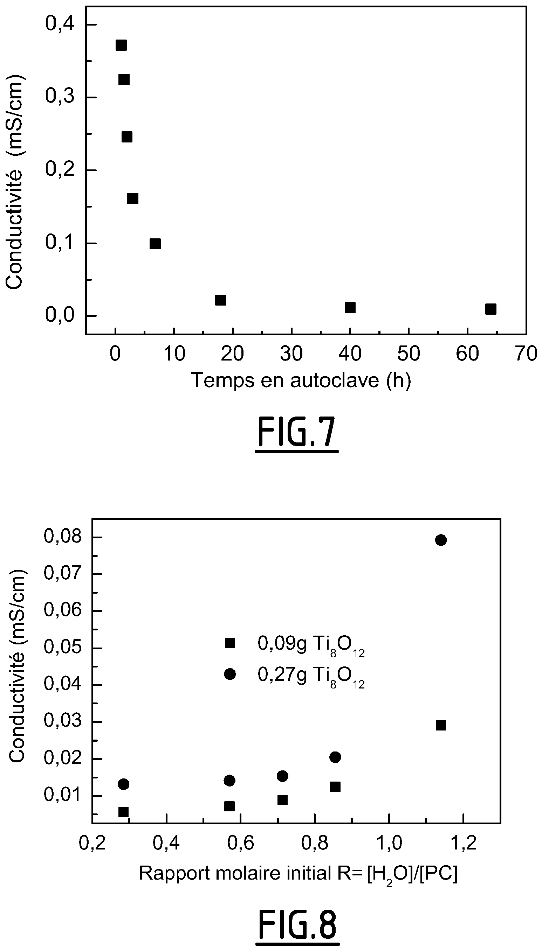

Toutefois, lors de l'ajout du carbonate de propylène et traitement thermique à 120°C, le propylène glycol issu de la réaction consomme l'acide HCl pour créer des molécules neutres : eau et 2-chloro 1-propanol. La neutralisation de la réaction peut être suivie par des mesures de conductivité. La figure 7 présente l'évolution de la conductivité de la solution colloïdale pour R=0,712 en fonction de la durée du traitement thermique à T=120°C. La conductivité, qui est proportionnelle à la concentration des ions, décroit continûment de 0,24mS/cm mesurée après 2 heures à 0,0094mS/cm après 64 heures de traitement à l'autoclave. Les faibles valeurs de la conductivité mesurées après 15h de traitement thermique révèlent que la quasi totalité des ions H⁺ et Cl⁻ est consommée.

Pour les deux concentrations en titane testées, les solutions colloïdales de différentes compositions en solvant, ayant subi des traitements thermiques identiques, présentent des valeurs de conductivité très faibles à l'exception de la solution avec R=[H₂O]/[PC] = 1,14 qui possède la conductivité la plus élevée et également la plus forte concentration en propylène glycol (Figure 8 : évolution de la conductivité de solution colloïdale en fonction du rapport R et pour différentes concentrations du précurseur).

### Exemple 4 : Diamètre des nanoparticules et agrégats

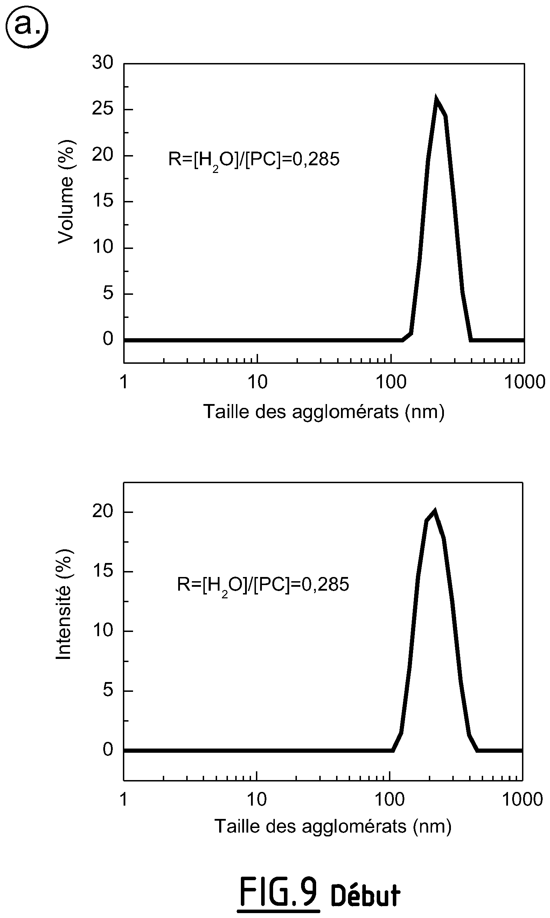

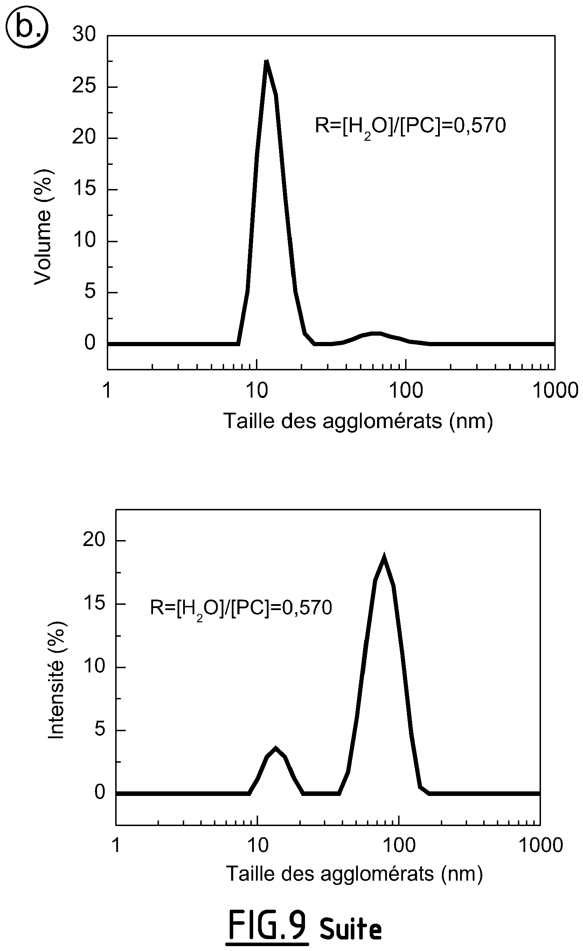

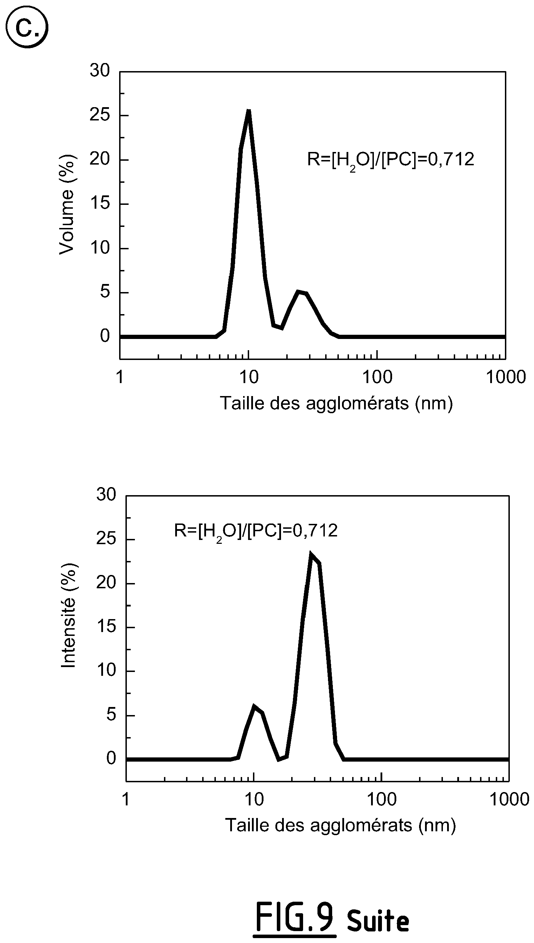

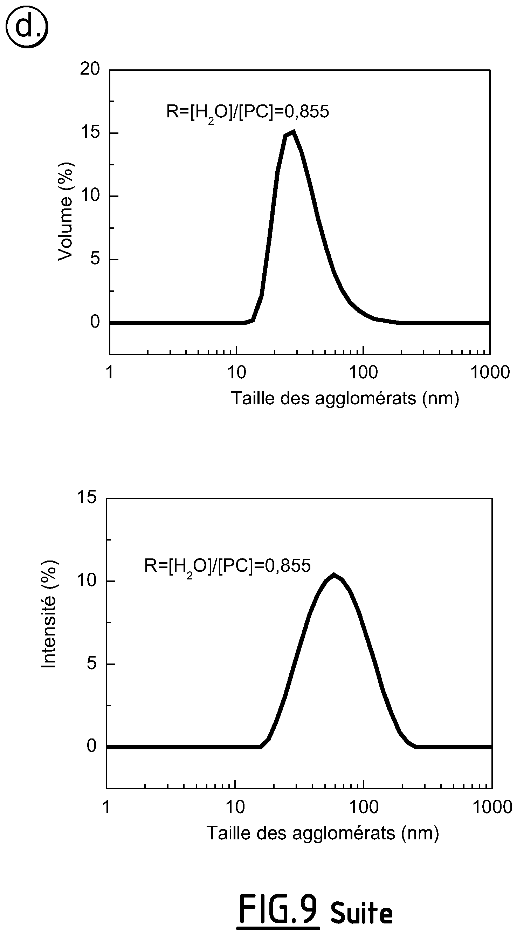

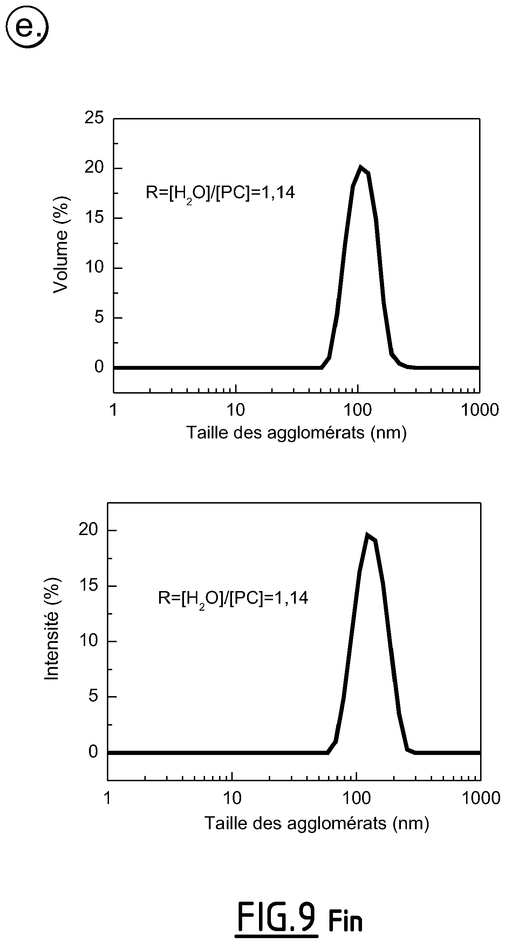

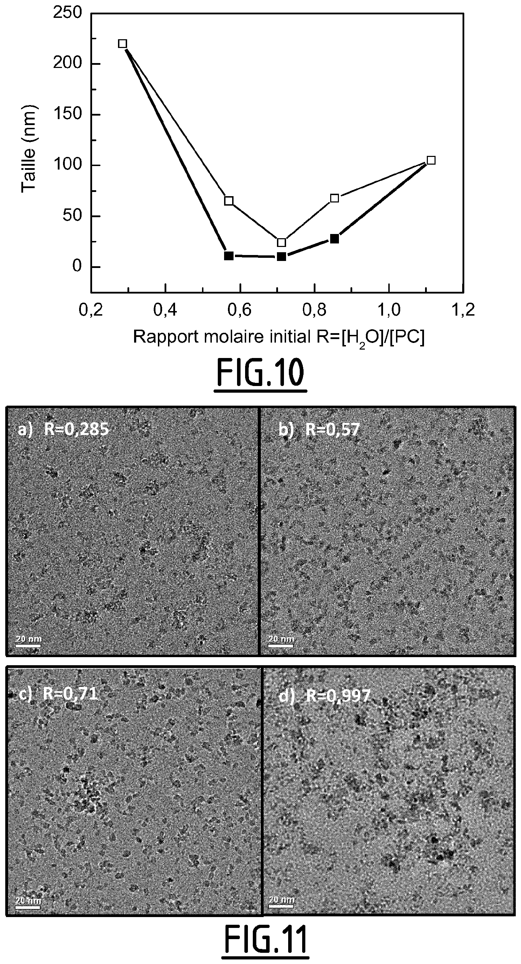

La taille des nanoparticules et agglomérats contenus dans les solutions colloïdales de différentes concentrations ([Ti] initiale = 0,05 M. L⁻¹, solutions N°7 à 12) a été mesurée par spectroscopie de corrélation de photons, 5 mois après la synthèse. La distribution de diamètres des particules, pour différents rapports molaires R=[H2O]/[PC] (0,285 <R< 1,14) de solutions colloïdales, est présentée sur la figure 9 en volume ou en intensité diffusée. La représentation en volume est plus réaliste dans le cas de petites particules tandis que le mode intensité est mieux adapté pour rendre compte de la présence de grosses particules en solution. Le diamètre des nanoparticules et agrégats en fonction de la formulation initiale des solutions colloïdales est reporté sur la figure 10. La taille en fonction du rapport molaire initial R=[H2O]/[PC] est rapporté pour les populations majoritaires (carrés pleins) et minoritaires (carrés vides).

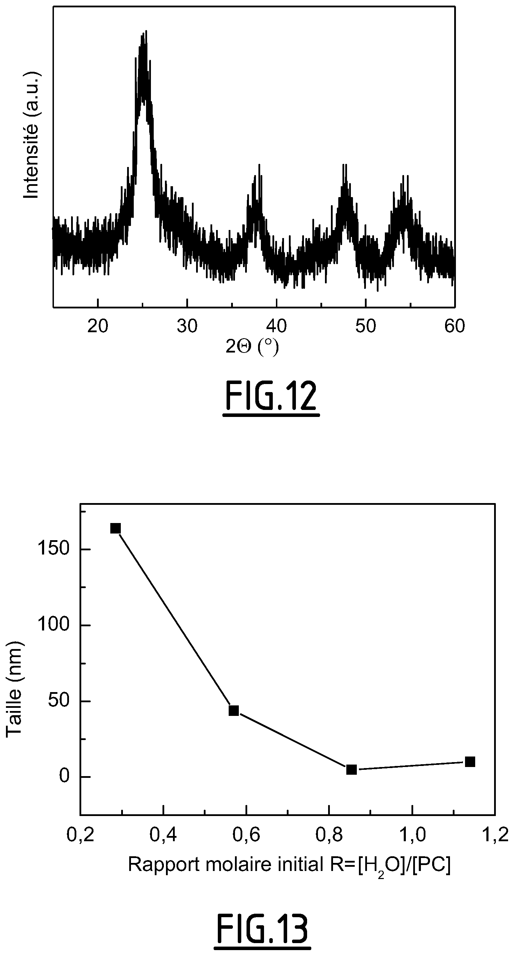

Les solutions avec R=0,285 et R=1,14 contiennent une seule population de particules de diamètre supérieur à 220nm et supérieur à 100nm, respectivement, tandis que celles de valeurs intermédiaires sont constituées de deux types de populations. Une solution quasi-mono-disperse avec un diamètre proche de 10nm est obtenue pour R=0,712. Les solutions colloïdales sont aisément diluées en milieu alcoolique (Images de Microcopie électronique à transmission, figure 11, où la solution colloïdale est diluée 100 fois dans l'éthanol, après illumination sous UV pendant 12h) et contiennent des nanoparticules de TiO₂ anatase (Diagramme de diffraction de rayons X figure 12 pour une poudre obtenue par séchage de la solution colloïdale à 70°C).

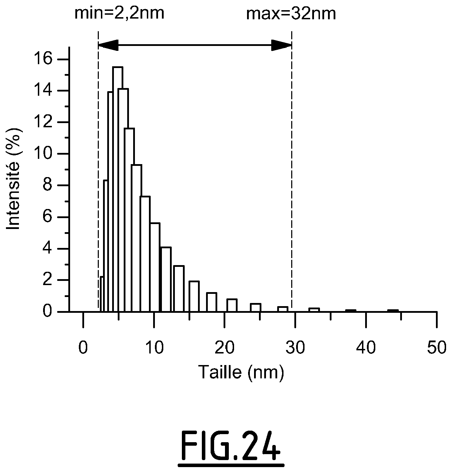

La figure 24 montre la distribution par PCS (Spectroscopie de Corrélation de Photons ou en anglais « Photon Corrélation Spectroscopy ») de la taille (diamètre hydrodynamique) des particules de la solution colloïdale N°9 avant illumination sous UV, qui est centrée sur 5 nm. On constate que la taille minimum de particules est de 2,2 nm et la taille maximum d'environ 32 nm. L'absence de distribution Gaussienne résulte de la limite physique de détection des particules de diamètre hydrodynamique inférieur à 1 nm.

### Exemple 5 : Amélioration de la qualité des solutions colloïdales par ajout de Propylène glycol.

Le propylène glycol est un produit de l'hydrolyse du carbonate de propylène. L'ajout de propylène glycol à la composition initiale carbonate de propylène/eau, améliore significativement les propriétés rhéologiques et la mono-dispersité des solutions colloïdales. Les formulations des solutions colloïdales explorées sont regroupées dans le tableau 4.

**Tableau 4: Préparation de solutions colloïdales avec différents rapports molaires R=[H₂O]/[PC] et ajout de propylène glycol (PG), valeurs de la viscosité des formulations après traitement en autoclave à 120°C pendant 60 heures.**

| Sol N° | Ti₈O₁₂ (g) | H₂O (moles) | PC (moles) | PG (moles) | R=[H₂O]/[PC] | D=[PG]/[PC] | Viscosité (cP) at 25°C |
|---|---|---|---|---|---|---|---|
| 19 | 0,32 | 0,056 | 0,195 | 0,039 | 0,285 | 0,2 | 5,00 |
| 20 | 0,32 | 0,111 | 0,195 | 0,039 | 0,570 | 0,2 | 8,40 |
| 21 | 0,32 | 0,167 | 0,195 | 0,039 | 0,855 | 0,2 | 18,5 |
| 22 | 0,32 | 0,222 | 0,195 | 0,039 | 1,140 | 0,2 | 24,8 |
| 23 | 0,16 | 0,167 | 0,195 | 0,039 | 0,855 | 0,2 | 17,15 |

| | | | | | | | |
|---|---|---|---|---|---|---|---|
| 0,16 g de Ti₈O₁₂ représente une concentration en titane : [Ti]= 0,0445 M.L-1 0,32 g de T Ti₈O₁₂ représente une concentration en titane : [Ti]= 0,089 M.L-1 | | | | | | | |

Les viscosités sont comprises entre 5 et 25 cP valeurs qui encadrent la gamme d'intérêt pour la technologie d'impression jet-d'encre. De plus, les solutions ne contenant qu'une seule population sont mono-disperses (Figure 13, avec les solutions N°19 à 22).

Ces formulations permettent d'ajuster également le diamètre des nanoparticules dans une large gamme, de 160nm pour R=0,285 et 43nm pour R=0,57, jusqu'à 5 et 10 nm pour les valeurs les plus élevées de R.

### Exemple 6 : Amélioration des propriétés d'absorption des solutions colloïdales sous illumination UV

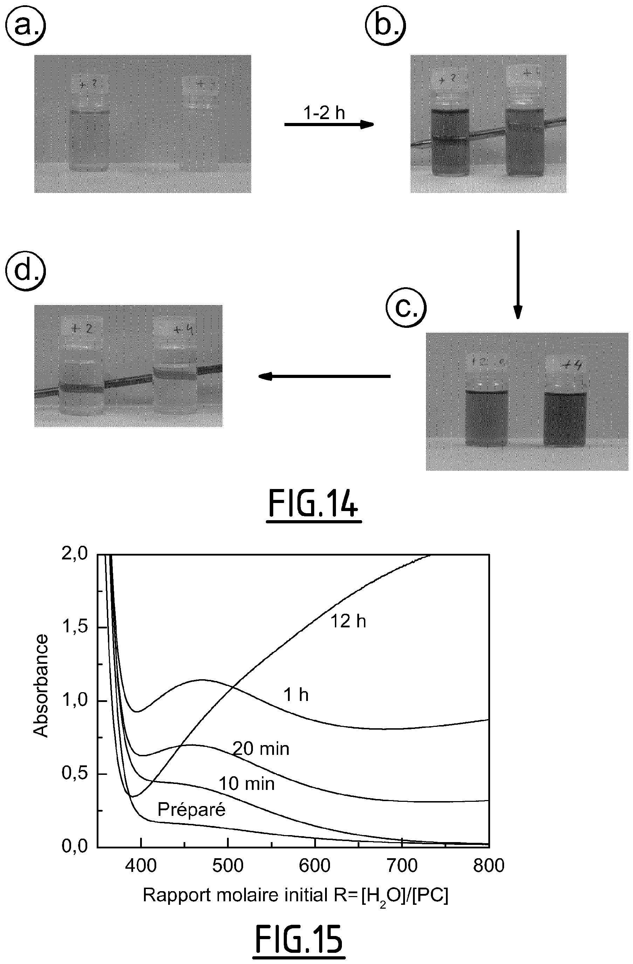

Toutes les solutions colloïdales préparées s'avèrent photosensibles sous illumination UV (Figure 14 : solution N°8 à gauche et solutions N°12 à droite, UV=365nm, 1mW/cm²). Les solutions initialement transparentes ou légèrement opaques (a) se colorent en rouge-orangé (b) après 1 à 2h d'exposition) puis en bleu-violet (c) après exposition prolongée à la lumière ultra-violette (nuit d'exposition ou environ 12h). Le changement de coloration se manifeste uniquement lorsque les flacons sont fermés hermétiquement. Au contact de l'oxygène de l'air, la solution bleu-violette se décolore et devient transparente (d). Les propriétés de dispersion des colloïdes sont modifiées après illumination. Alors que les solutions initiales N°8 et N°12 sont respectivement transparente (diamètre des particules ∼ 20nm) et légèrement opaque (diamètre de particule ∼ 100nm), après exposition sous UV pendant une nuit puis contact à l'air la solution N°12 devient transparente avec un diamètre moyen de particules d'environ 50nm. Un comportement similaire est observé pour tous les échantillons. Ce phénomène résulte de réactions d'oxydo-réduction qui se produisent, sous illumination UV, à l'interface nanoparticule d'oxyde de titane/adsorbat. La coloration rouge serait attribuable à la formation d'espèces peroxo en présence d'oxygène tandis que la couleur bleue résulte de la formation de Ti3+.

Les solutions initialement transparentes ou opaques présentent un spectre d'absorption caractéristique avec un front d'absorption en dessous de 400nm (Figure 15 : spectre d'absorbance UV-visible de la solution N°23, R=[H2O]/[PC]=0,855 avant et après différents temps d'illumination sous UV=365nm). Durant les premières minutes d'illumination UV une bande d'absorption se manifeste à environ 470 nm (la solution de colore en rouge-orangé). Après une illumination prolongée de 12h, les bandes d'absorption précédentes disparaissent pour laisser place à une large bande située dans le domaine visible-proche IR qui est responsable de la coloration bleue des solutions.

### Exemple 7 (pas selon l'invention)

: Solutions colloïdales à base d'oxyde de titane et des solvants eau/ Propylène Glycol.

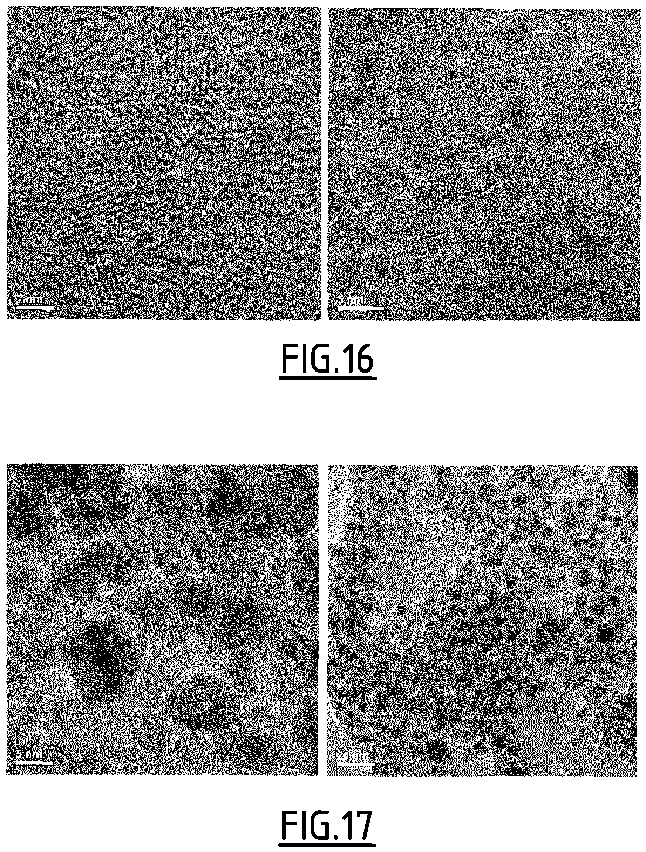

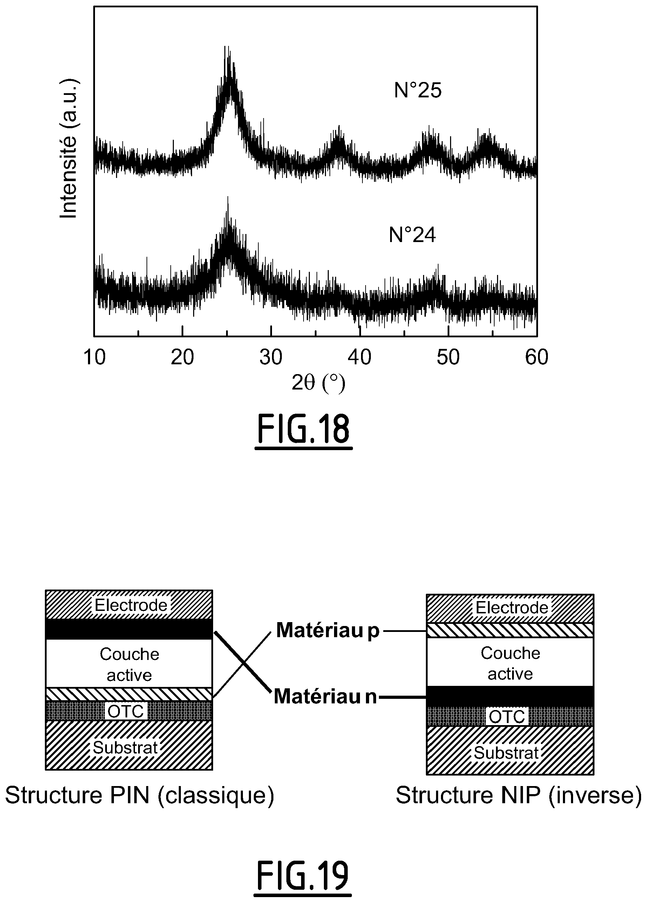

Alternativement, des solutions colloïdales de TiOx /TiO₂ peuvent être préparées en utilisant le précurseur [Ti₈O₁₂(H₂O)₂₄]Cl₈•HCl•7H₂O et le mélange eau/propylène glycol (PG) comme solvant. La synthèse est réalisée en autoclave à 120°C pendant 48h. Par un ajustement du rapport R=[H2O]/[PG] il est possible de contrôler la viscosité et la stabilité des solutions colloïdales ainsi que la taille des nanoparticules d'anatase entre 2 et 7 nm (diamètre hydrodynamique). (Tableau 5 et figures 16, 17, 18 : images au microscope électronique haute résolution de la solution N°24 (R=0,171) (figure 16) et N°25 (R=0,555) (figure 17) ; pour les figures 16 et 17 les solutions colloïdales sont diluées 10 fois dans l'éthanol ; figure 18 : diagramme de diffraction de rayons X des poudres obtenues par séchage des solutions 24 et 25 à 70°C).

**Tableau 5: Préparation de solutions colloïdales avec différents rapports molaires R=[H₂O]/[PG] et valeurs de la viscosité des formulations après traitement en autoclave à 120°C pendant 48 heures.**

| N° des Solutions | Ti₈O₁₂ [g] | H₂O [moles] | PG [moles] | R=[H₂O]/[PG] | Viscosité en cP (25°C) |
|---|---|---|---|---|---|
| 24 | 0,18 | 0,056 | 0,327 | 0,171 | 36,13 |
| 25 | 0,18 | 0,166 | 0,299 | 0,555 | 24,88 |

| | | | | | |
|---|---|---|---|---|---|
| 0,18 g de Ti₈O₁₂ représente une concentration en titane : [Ti]= 0,05 M.L-1 | | | | | |

### Exemple 8 : Applications aux cellules photovoltaïques organiques de type PIN et NIP

La mise en oeuvre des formulations a été validée par des techniques d'enduction et d'impression par jet d'encre et intégrée au processus de fabrication de cellules photovoltaïques NIP ou PIN (Figure 19 : vue schématique de différents constituants de cellule photovoltaïque PIN ou NIP).

Les solutions colloïdales à base d'oxyde de titane sont utilisées pour la réalisation de la couche mince semiconductrice de type n.

### Exemple 9 : Procédés de réalisation de la couche inter-faciale n

La solution colloïdale de l'invention est déposée sur un substrat conducteur ou semi-conducteur transparent. Les méthodes de dépôt utilisés peuvent être choisies parmi le spin coating, l'enduction/épandage (Dr Blade, « coulage en bande »), les méthodes d'impression (jet d'encre, screen printing, heliogravure,...), etc. Il est possible d'utiliser également un « patterning » (motifs) du substrat.

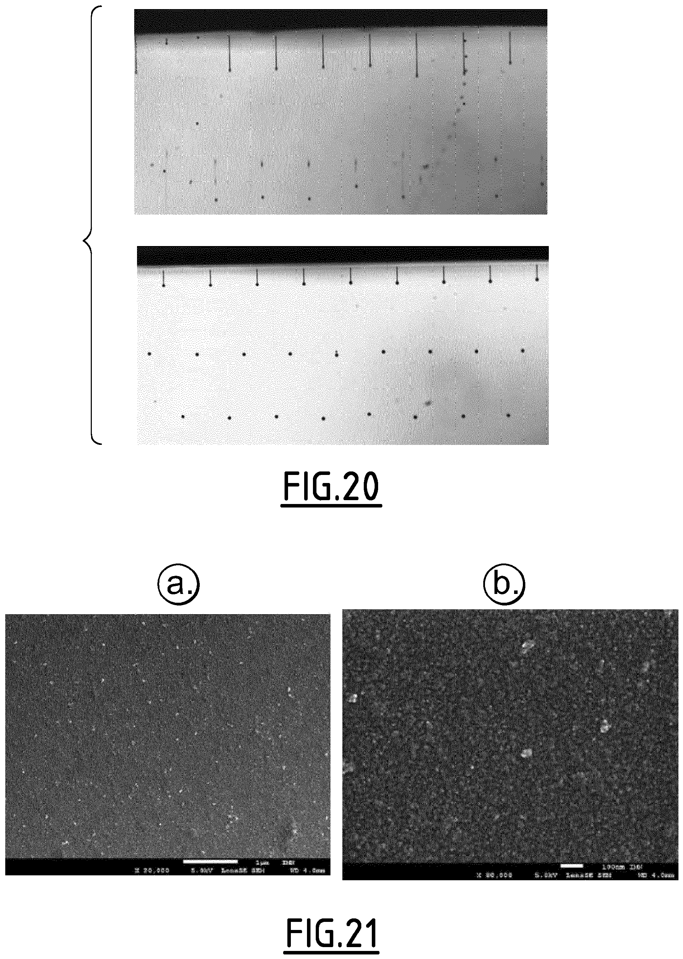

L'emploi de l'impression jet d'encre permet de réaliser une couche directement structurée correspondant au design souhaité pour la cellule et les paramètres associées aux procédés de contrôler les caractéristiques des couches réalisées (épaisseur, couche(s) sous-jacente(s), ...) (Figure 20 : capture de gouttes en vol à la sortie d'un module d'impression industrielle avant et après optimisation des paramètres d'éjection (formulation optimisée pour le jet d'encre à partir d'une solution colloïdale de TiOₓ ; et Figure 21: Microscopie électronique à balayage d'une couche de TiOₓ imprimée par jet d'encre sur un substrat verre/ITO (étapes du processus de fabrication d'une cellule OPV en structure NIP ; (a) grossissement x 20 000, (b) grossissement x 80 000). Ce procédé permet également de minimiser les pertes de matière dans la mise en oeuvre.

A partir des formulations décrites précédemment, la couche de TiOₓ est réalisée par impression jet d'encre à l'aide d'une plateforme d'impression intégrant des modules d'impression générant des gouttes de 1 pL à 100 pL (pL: pico-litre). Suivant la nature de la couche sous-jacente, les stratégies d'impression sont adaptées afin d'obtenir des couches homogènes d'épaisseur visée, ainsi que la concentration en TiOₓ de la formulation utilisée. Le recuit thermique appliqué est similaire à celui utilisé pour les couches réalisées par enduction. La couche n selon l'invention est utilisée sur une surface conductrice ou semi-conductrice de cellules solaires organiques ou hybrides, photodiodes (application capteur), diodes électroluminescentes.

### Elaboration des cellules photovoltaïques :

Les cellules photovoltaïques préparées comportent un substrat de verre ou de plastique (PET, PEN), recouvert d'une couche d'ITO qui est elle-même recouverte d'un oxyde semiconducteur n TiOₓ Celle-ci est recouverte d'un film actif composé d'un mélange P3HT/PCBM. La couche active est revêtue successivement d'une couche de PEDOT :PSS ou autre matériau semi-conducteur dopé de type p (HTL Hole Transporting Layer) puis d'une anode à l'argent. La configuration de la cellule est donc la suivante : substrat/ITO/TiOx/polymère + PCBM/PEDOT:PSS ou autre HTL/Ag.

Les conditions de dépôt par enduction centrifuge (dépôt à la tournette) sont les suivantes : Etape 1 : Une couche de TiOₓ est élaborée à partir d'une solution précurseur par dépôt à la tournette (Solution N°9 après illumination UV pendant 12 h). La durée de l'enduction est de 60s à 1000 tr.min-1 puis 30 s à 2000 tr.min-1. L'épaisseur de la couche obtenue est d'environ 50 nm, le dépôt est réalisé à l'air, puis séché sur plaque chauffante à 150°C pendant 1h.

Etape 2 : Le dépôt de la couche active est réalisé par dépôt à la tournette d'une composition de P3HT/PCBM, sur la couche n, à environ 1500 tr.min-1 pendant 40 s puis 2000 tr.min-1 pendant 35 s.

Etape 3 : Une couche d'HTL (environ 50 nm) est déposée à la tournette à 2000 tr.min-1 pendant 25 s puis 3000 tr.min-1 pendant 25 s.

La cellule ainsi préparée est alors recuite en boite à gants pendant 15 mn à 150°C. Etape 4 : Une électrode d'argent (100 nm) est ensuite évaporée sous vide.

Les cellules sont ensuite caractérisées en boîte à gants sous atmosphère contrôlée. Les caractéristiques courant-tension (I(V)) sont enregistrées sur un appareil Keithley® SMU 2400 sous éclairement AM1,5 à une puissance de 1000 W.m.

### Performances mesurées :

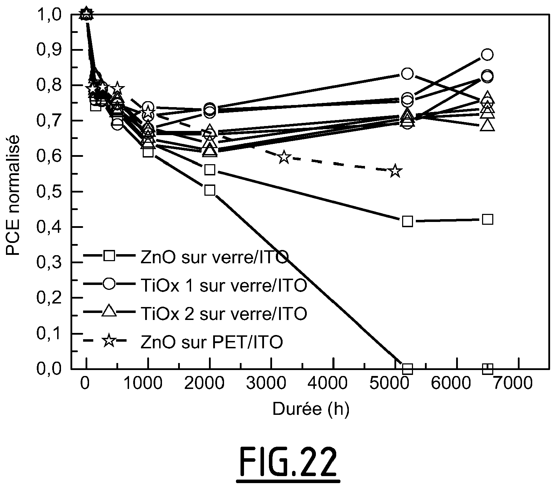

L'utilisation de cette structure permet d'obtenir des performances globalement supérieures à une structure de référence permettant de maintenir une stabilité élevée des dispositifs (figure 22).

On constate sur la figure 22 que la durée de vie des cellules photovoltaïques fabriquées par l'utilisation de la solution colloïdale de l'invention permet d'augmenter la durée de vie de manière très significative avec un rendement tout à fait satisfaisant, avec une perte faible de rendement sur la durée testée.

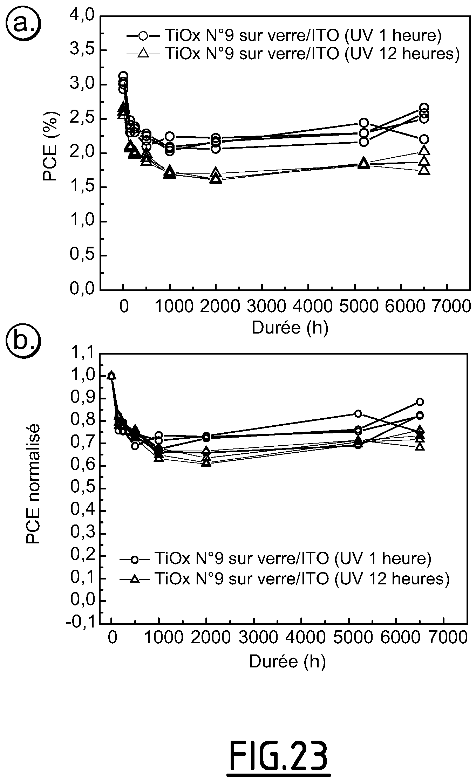

Le Tableau 6 résume les rendements de conversion photovoltaïque des dispositifs réalisés. L'étude de leur vieillissement (encapsulation flexible, AM1.5, 100 mW.cm-2, 45°C) est présenté sur les figures 22 et 23. Comparativement au matériau de référence (ZnO), l'insertion de la couche TiOₓ augmente la durée de vie de la cellule et accroit son rendement avec une perte inférieure à 15% sur 6500h.

**Tableau 6 : Performances des cellules mises en œuvre par le 1^{er} procédé initialement (à t=0)**

| ***TiOx*** | ***Substrat*** | ***Epaisseur (nm)*** | ***Voc (mV)*** | ***Jsc (mA*/*cm²)*** | ***FF (%)*** | ***PCE (%)*** |
|---|---|---|---|---|---|---|
| **TiOₓ1*** | verre | 45 non continu | 499 | 11.6 | 38.6 | **2.24** |
| **TiOₓ2*** | plastique | 50 | 579 | 9.59 | 56.89 | 3.16 |
| TiO**ₓ**2* | verre | 50 | 600 | 11.2 | 55.22 | 3.70 |
| **TiOₓ2*** | verre | 130 | 580 | 12.0 | 48.9 | **3.41** |
| **TiOₓ3*** | verre | 150 | 536 | 11.9 | 44.4 | **2.82** |
| ***Ref. ZnO*** | plastique | - | *583* | *9.39* | *58.0* | ***3.18*** |
| ***Ref. ZnO*** | verre | - | *607* | *12.3* | *55.0* | ***4.10*** |

| | | | | | | |
|---|---|---|---|---|---|---|
| *TiOₓ 1 : solution N°9 sans illumination UV ; TiOₓ 2 : solution N°9 après illumination UV pendant 12h (solution bleue) ; TiOₓ 3 : après illumination UV pendant 1h (solution orange-rouge) | | | | | | |

## Revendications

1. Procédé de préparation d'une solution colloïdale de nanoparticules d'oxyde de titane, **caractérisé en ce qu'**il comprend (a) la dissolution d'un précurseur d'oxyde de titane dit « précurseur » dans un solvant du précurseur, ledit solvant du précurseur comprenant au moins de l'eau et du carbonate de propylène (PC), ledit précurseur d'oxyde de titane étant choisi parmi l'aqua-oxo-chlorure de titane, TiOSO₄, TiCl₄, TiF₄, TiOF2, et un alcoxyde de titane en milieu acide, et (b) la transformation chimique par hydrolyse dudit précurseur en oxyde de titane et du carbonate de propylène en un solvant de solution colloïdale, l'eau étant consommée, en totalité ou en partie, par la transformation chimique du carbonate de propylène, et ledit du carbonate de propylène étant transformé, en totalité ou en partie par hydrolyse en un troisième solvant, pour former des nanoparticules d'oxyde de titane dispersées dans le solvant de solution colloïdale comprenant au moins le troisième solvant, et éventuellement l'eau et du carbonate de propylène, ladite solution colloïdale présentant une viscosité dynamique comprise entre 4 et 54 cP à 20°C et 101 325 Pa, la viscosité étant contrôlée par l'arrêt de l'étape de transformation chimique du solvant du précurseur.

2. Procédé selon la revendication 1, **caractérisé en ce que** la viscosité dynamique de la solution colloïdale de nanoparticules est comprise entre 4 et 25 cP, à 20°C et 101 325 Pa.

3. Procédé selon la revendication 1, **caractérisé en ce que** la viscosité dynamique de la solution colloïdale de nanoparticules est comprise entre 8 et 15 cP, à 20°C et 101 325 Pa.

4. Procédé selon l'une quelconque des revendications précédentes, **caractérisé en ce qu'**il comprend la mise en contact du précurseur d'oxyde de titane avec un solvant biphasé comprenant au moins de l'eau et du carbonate de propylène puis la transformation du solvant biphasé par hydrolyse en un solvant monophasé comprenant des nanoparticules d'oxyde de titane.

5. Procédé selon l'une quelconque des revendications 1 à 4, **caractérisé en ce que** le procédé comprend l'hydrolyse de carbonate de propylène en acide carbonique et en propane-diol.

6. Procédé selon l'une quelconque des revendications 1 à 5, **caractérisé en ce que** le propane-diol s'hydrolyse en 2-chloro-propan-1-ol en présence d'acide chlorhydrique.

7. Procédé selon l'une quelconque des revendications 1 à 6, **caractérisé en ce que** le solvant du précurseur présente un rapport molaire [eau]/[PC] compris entre 0,1 et 1,5, et de préférence entre 0,2 et 1,2, et encore de préférence compris entre 0,5 et 0,8.

8. Procédé selon l'une quelconque des revendications 1 à 7, **caractérisé en ce que** la concentration du précurseur exprimée en concentration en titane est comprise entre 0,005 et 0,1 M.L⁻¹.

9. Procédé selon l'une quelconque des revendications 1 à 8, **caractérisé en ce que** la transformation du précurseur en oxyde de titane produit de l'acide chlorhydrique, et **en ce que** l'acide chlorhydrique produit est consommé par réaction avec au moins un composé dudit solvant du précurseur ou un composé formé lors de la transformation chimique du solvant du précurseur.

10. Procédé selon l'une quelconque des revendications 1 à 9, **caractérisé en ce que** l'on ajoute au solvant du précurseur du solvant de solution colloïdale, ou un solvant faisant parti du solvant de solution colloïdale.

11. Procédé selon l'une quelconque des revendications 1 à 10, **caractérisé en ce que** la solution colloïdale de nanoparticules d'oxyde de titane est exposée aux rayons UV pour améliorer ses propriétés d'absorption du rayonnement solaire.

12. Solution colloïdale de nanoparticules d'oxyde de titane **caractérisée en ce qu'**elle est obtenue par un procédé selon l'une quelconque des revendications 1 à 10.

13. Solution colloïdale selon la revendication 12, **caractérisée en ce qu'**elle comprend des nanoparticules d'oxyde de titane sous forme d'anatase ; et de préférence présentant un diamètre hydrodynamique des nanoparticules compris entre 2 et 50 nm et d'agrégats, s'ils sont présents, ayant de préférence un diamètre hydrodynamique compris entre 50 et 250 nm, et de préférence comprise entre 50 et 180 nm.

14. Utilisation d'une solution colloïdale telle que définie selon l'une quelconque des revendications 12 à 13, ou susceptible d'être obtenue selon le procédé tel que défini selon l'une quelconque des revendications 1 à 11, pour la préparation d'un semi-conducteur de type n.

15. Procédé de préparation d'une couche de semi-conducteur de type n, **caractérisé en ce qu'**il comprend la préparation d'une solution colloïdale telle que définie à l'une quelconque des revendications 12 à 13, ou susceptible d'être obtenue selon le procédé tel que défini selon l'une quelconque des revendications 1 à 11, et le dépôt par impression d'une couche de solution colloïdale sur un substrat pour former une couche de semi-conducteur de type n comprenant des nanoparticules d'oxyde de titane.

16. Procédé, selon la revendication 15, **caractérisé en ce que** le dépôt est opéré par impression, et de préférence par impression par jet d'encre.

17. Procédé, selon la revendication 15 ou 16, **caractérisé en ce qu'**il comprend le dépôt de la solution colloïdale sur un substrat, suivi d'un recuit à une température comprise entre 50 et 500° C.

18. Dispositif photovoltaïque **caractérisé en ce qu'**il comprend un matériau semi-conducteur de type n susceptible d'être obtenu selon l'une quelconque des revendications 15 à 17.

19. Dispositif photovoltaïque, selon la revendication 18 **caractérisé en ce qu'**il constitue une cellule photovoltaïque de type PIN ou NIP, un transistor organique, ou une diode électroluminescente.

20. Procédé de fabrication d'un dispositif photovoltaïque **caractérisé en ce qu'**il comprend la préparation d'une couche de semi-conducteur de type n, telle que définie selon l'une quelconque des revendications 15 à 17.

21. Méthode de production d'énergie **caractérisée en ce qu'**elle comprend l'utilisation d'un matériau semi-conducteur de type n susceptible d'être obtenu selon l'une quelconque des revendications 15 à 17, ou d'un dispositif photovoltaïque tel que défini selon la revendication 18 ou 19, pour produire de l'énergie à partir de radiations solaires.

## Patentansprüche

1. Verfahren zur Herstellung einer kolloidalen Lösung von Nanopartikeln des Titanoxids, **dadurch gekennzeichnet, dass** es umfasst (a) das Lösen eines Vorläufers des Titanoxids, genannt "Vorläufer", in einem Lösungsmittel des Vorläufers, wobei das Lösungsmittel mindestens Wasser und Propylenkarbonat (PC) umfasst, wobei der Vorläufer des Titanoxids ausgewählt ist aus Titan-aquo-oxo-chlorid, TiOSO₄, TiCl₄, TiF₄, TiOF₄ und Titanalkoxid in saurem Medium und (b) die chemische Transformation durch Hydrolyse des Vorläufers in Titanoxid und des Propylenkarbonats in ein Lösungsmittel der kolloidalen Lösung, wobei das Wasser insgesamt oder teilweise durch die chemische Transformation des Propylenkarbonats verbraucht wird, und das Propylenkarbonat insgesamt oder teilweise durch Hydrolyse in ein drittes Lösungsmittel transformiert wird, um Nanopartikel des Titanoxids zu bilden, die in dem Lösungsmittel der kolloidalen Lösung verteilt sind, das mindestens das dritte Lösungsmittel und gegebenenfalls Wasser und Propylenkarbonat enthält, wobei die kolloidale Lösung eine dynamische Viskosität zwischen 4 und 54 cP bei 20°C und 101 325 Pa aufweist, wobei die Viskosität durch Anhalten des Schrittes der chemischen Transformation des Lösungsmittels des Vorläufers gesteuert wird.

2. Verfahren nach Anspruch 1, **dadurch gekennzeichnet, dass** die dynamische Viskosität der kolloidalen Lösung von Nanopartikeln zwischen 4 und 25 cP bei 20°C und 101 325 Pa liegt.

3. Verfahren nach Anspruch 1, **dadurch gekennzeichnet, dass** die dynamische Viskosität der kolloidalen Lösung von Nanopartikeln zwischen 8 und 15cP bei 20°C und 101 325 Pa liegt.

4. Verfahren nach einem beliebigen der vorhergehenden Ansprüche, **dadurch gekennzeichnet, dass** es das Inkontaktbringen des Vorläufers des Titanoxids mit einem zweiphasigen Lösungsmittel, das mindestens Wasser und Propylenkarbonat enthält, und dann die Transformation des zweiphasigen Lösungsmittels durch Hydrolyse in ein einphasiges Lösungsmittel, das die Nanopartikel des Titanoxids umfasst.

5. Verfahren nach einem beliebigen der Ansprüche 1 bis 4, **dadurch gekennzeichnet, dass** das Verfahren die Hydrolyse des Propylenkarbonats in Kohlensäure und Propandiol umfasst.

6. Verfahren nach einem beliebigen der Ansprüche 1 bis 5, **dadurch gekennzeichnet, dass** das Propandiol in 2-chloro-propan-1-ol in Anwesenheit von Salzsäure hydrolysiert wird.

7. Verfahren nach einem beliebigen der Ansprüche 1 bis 6, **dadurch gekennzeichnet, dass** das Lösungsmittel des Vorläufers ein Molverhältnis [Wasser]/[PC] zwischen 0,1 und 1,5, vorzugsweise zwischen 0,2 und 1,2 und noch bevorzugter zwischen 0,5 und 0,8 aufweist.

8. Verfahren nach einem beliebigen der Ansprüche 1 bis 7, **dadurch gekennzeichnet, dass** die Konzentration des Vorläufers, ausgedrückt in Konzentration an Titan, zwischen 0,005 und 0,1 M.L⁻¹ liegt.

9. Verfahren nach einem beliebigen der Ansprüche 1 bis 8, **dadurch gekennzeichnet, dass** die Transformation des Vorläufers in Titanoxid Salzsäure erzeugt und dass die erzeugte Salzsäure durch Reaktion mit mindestens einer Verbindung des Lösungsmittels des Vorläufers oder einer Verbindung, die während der chemischen Transformation des Lösungsmittels des Vorläufers gebildet wird, verbraucht wird.

10. Verfahren nach einem beliebigen der Ansprüche 1 bis 9, **dadurch gekennzeichnet, dass** dem Lösungsmittel des Vorläufers Lösungsmittel der kolloidalen Lösung oder ein Lösungsmittel, das Teil des kolloidalen Lösungsmittels ist, hinzugefügt wird.

11. Verfahren nach einem beliebigen der Ansprüche 1 bis 10, **dadurch gekennzeichnet, dass** die kolloidale Lösung von Nanopartikeln des Titanoxids einer UV Strahlung ausgesetzt wird, um ihre Eigenschaften der Absorption der Sonnenstrahlung zu verbessern.

12. Kolloidale Lösung von Nanopartikeln des Titanoxids, **dadurch gekennzeichnet, dass** sie durch ein Verfahren nach einem beliebigen der Ansprüche 1 bis 10 erhalten wird.

13. Kolloidale Lösung nach Anspruch 12, **dadurch gekennzeichnet, dass** sie Nanopartikel des Anatas-Titanoxids und die vorzugsweise einen hydrodynamischen Durchmesser der Nanopartikel zwischen 2 und 50nm aufweisen, und Anhäufungen enthält, die, wenn sie vorhanden sind, vorzugsweise einen hydrodynamischen Durchmesser zwischen 50 und 250 nm und vorzugsweise zwischen 50 und 180 nm aufweisen.

14. Verwendung einer kolloidalen Lösung, wie sie nach einem beliebigen der Ansprüche 12 bis 13 definiert ist, oder die geeignet ist, nach einem Verfahren, wie es nach einem beliebigen der Ansprüche 1 bis 11 definiert ist, erhalten zu werden, für die Herstellung eines Halbleiters des n-Typs.

15. Verfahren zur Herstellung einer Halbleiterschicht des n-Typs, **dadurch gekennzeichnet, dass** es die Herstellung einer kolloidalen Lösung, wie sie nach einem beliebigen der Ansprüche 12 bis 13 definiert ist, oder die geeignet ist, nach einem Verfahren, wie es nach einem beliebigen der Ansprüche 1 bis 11 definiert ist, erhalten zu werden, und die Ablagerung durch Aufdrucken einer Schicht der kolloidalen Lösung auf ein Substrat umfasst, um eine Halbleiterschicht des n-Typs zu bilden, die Nanopartikel des Titanoxids enthält.

16. Verfahren nach Anspruch 15, **dadurch gekennzeichnet, dass** die Ablagerung durch Aufdrucken und vorzugsweise durch Aufdrucken mit einem Tintenstrahl durchgeführt wird.

17. Verfahren nach Anspruch 15 oder 16, **dadurch gekennzeichnet, dass** es die Ablagerung der kolloidalen Lösung auf einem Substrat, gefolgt von einem Glühen bei einer Temperatur zwischen 50 und 500°C umfasst.

18. Photovoltaische Vorrichtung, **dadurch gekennzeichnet, dass** sie ein Halbleitermaterial des n-Typs enthält, das geeignet ist, nach einem beliebigen der Ansprüche 15 bis 17 erhalten zu werden.

19. Photovoltaische Vorrichtung nach Anspruch 18, **dadurch gekennzeichnet, dass** sie eine photovoltaische Zelle des Typs PIN oder NIP, einen organischen Transistor oder eine Lumineszenzdiode darstellt.

20. Verfahren zur Herstellung einer photovoltaischen Vorrichtung, **dadurch gekennzeichnet, dass** es die Herstellung einer Halbleiterschicht des n-Typs, wie sie nach einem beliebigen der Ansprüche 15 bis 17 definiert ist, umfasst.

21. Verfahren zur Energieerzeugung, **dadurch gekennzeichnet, dass** es die Verwendung des Halbleitermaterials des n-Typs, das geeignet ist, nach einem beliebigen der Ansprüche 15 bis 17 erhalten zu werden, oder eine photovoltaischen Vorrichtung, wie sie nach den Ansprüchen 18 oder 19 definiert ist, zur Erzeugung von Energie aus Sonnenstrahlung umfasst.

## Claims

1. Method for preparing a colloidal solution of titanium oxide nanoparticles, **characterised in that** it comprises (a) dissolving a precursor of titanium oxide, called the "precursor", in a solvent of the precursor, said solvent of the precursor comprising at least water and propylene carbonate (PC), said precursor of titanium oxide being chosen from titanium aqua-oxo chloride, TiOSO₄, TiCl₄, TiF₄, TiOF₂, and a titanium alkoxide in an acidic medium, and (b) chemically converting said precursor to titanium oxide and the propylene carbonate to a colloidal solution solvent by hydrolysis, the water being consumed, wholly or in part, by the chemical conversion of the propylene carbonate, and said propylene carbonate being converted, wholly or in part, to a third solvent by hydrolysis, to form titanium oxide nanoparticles dispersed in the colloidal solution solvent comprising at least the third solvent, and optionally water and propylene carbonate, said colloidal solution having a dynamic viscosity of between 4 and 54 cP at 20°C and 101,325 Pa, the viscosity being controlled by stopping the step of chemical conversion of the solvent of the precursor.

2. Method according to claim 1, **characterised in that** the dynamic viscosity of the colloidal solution of nanoparticles is between 4 and 25 cP at 20°C and 101,325 Pa.

3. Method according to claim 1, **characterised in that** the dynamic viscosity of the colloidal solution of nanoparticles is between 8 and 15 cP at 20°C and 101,325 Pa.

4. Method according to any one of the preceding claims, **characterised in that** it comprises bringing the precursor of titanium oxide into contact with a two-phase solvent comprising at least water and propylene carbonate and then converting the two-phase solvent to a single-phase solvent comprising titanium oxide nanoparticles by hydrolysis.

5. Method according to any one of claims 1 to 4, **characterised in that** the method comprises hydrolysing propylene carbonate to carbonic acid and propanediol.

6. Method according to any one of claims 1 to 5, **characterised in that** the propanediol hydrolyses to 2-chloropropan-1-ol in the presence of hydrochloric acid.

7. Method according to any one of claims 1 to 6, **characterised in that** the solvent of the precursor has a molar ratio [water]/[PC] of between 0.1 and 1.5, preferably between 0.2 and 1.2, yet more preferably between 0.5 and 0.8.

8. Method according to any one of claims 1 to 7, **characterised in that** the concentration of the precursor, expressed as the concentration of titanium, is between 0.005 and 0.1 M.L⁻¹.

9. Method according to any one of claims 1 to 8, **characterised in that** the conversion of the precursor to titanium oxide produces hydrochloric acid, and **in that** the hydrochloric acid produced is consumed by reaction with at least one compound of said solvent of the precursor or a compound formed in the chemical conversion of the solvent of the precursor.

10. Method according to any one of claims 1 to 9, **characterised in that** colloidal solution solvent, or a solvent that forms part of the colloidal solution solvent, is added to the solvent of the precursor.

11. Method according to any one of claims 1 to 10, **characterised in that** the colloidal solution of titanium oxide nanoparticles is exposed to UV radiation in order to improve its properties of absorbing solar radiation.

12. Colloidal solution of titanium oxide nanoparticles, **characterised in that** it is obtained by a method according to any one of claims 1 to 10.

13. Colloidal solution according to claim 12, **characterised in that** it comprises nanoparticles of titanium oxide in anatase form; and preferably having a hydrodynamic diameter of the nanoparticles of between 2 and 50 nm, and aggregates, if they are present, preferably having a hydrodynamic diameter of between 50 and 250 nm, preferably between 50 and 180 nm.

14. Use of a colloidal solution as defined according to any one of claims 12 to 13, or obtainable by the method as defined according to any one of claims 1 to 11, in the preparation of an n-type semiconductor.

15. Method for preparing an n-type semiconductor layer, **characterised in that** it comprises preparing a colloidal solution as defined in any one of claims 12 to 13, or obtainable by the method as defined according to any one of claims 1 to 11, and depositing a layer of colloidal solution on a substrate by printing to form an n-type semiconductor layer comprising titanium oxide nanoparticles.

16. Method according to claim 15, **characterised in that** the deposition is carried out by printing, preferably by ink-jet printing.

17. Method according to claim 15 or 16, **characterised in that** it comprises depositing the colloidal solution on a substrate, followed by annealing at a temperature of between 50 and 500°C.

18. Photovoltaic device, **characterised in that** it comprises an n-type semiconductor material obtainable by any one of claims 15 to 17.

19. Photovoltaic device according to claim 18, **characterised in that** it is a PIN- or NIP-type photovoltaic cell, an organic transistor or an electroluminescent diode.

20. Method for manufacturing a photovoltaic device, **characterised in that** it comprises preparing an n-type semiconductor layer as defined according to any one of claims 15 to 17.

21. Method for producing energy, **characterised in that** it comprises using an n-type semiconductor material obtainable according to any one of claims 15 to 17 or a photovoltaic device as defined according to claim 18 or 19 to produce energy from solar radiation.
